(19) Europäisches Patentamt
European Patent Office
Office européen des brevets

(11) EP 2 944 703 A1

(12) **EUROPEAN PATENT APPLICATION**
published in accordance with Art. 153(4) EPC

(43) Date of publication:
**18.11.2015 Bulletin 2015/47**

(51) Int Cl.:
*C22C 9/04* (2006.01)          *C22F 1/08* (2006.01)
*C25D 7/00* (2006.01)          *H01B 1/02* (2006.01)
*H01B 5/02* (2006.01)          *H01B 13/00* (2006.01)
*C22F 1/00* (2006.01)

(21) Application number: **13870528.0**

(22) Date of filing: **10.07.2013**

(86) International application number:
**PCT/JP2013/068834**

(87) International publication number:
**WO 2014/109083 (17.07.2014 Gazette 2014/29)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **09.01.2013 JP 2013002112**

(71) Applicants:
• **Mitsubishi Materials Corporation**
  **Chiyoda-ku**
  **Tokyo 100-8117 (JP)**
• **Mitsubishi Shindoh Co., Ltd.**
  **Tokyo 140-8550 (JP)**

(72) Inventors:
• **MAKI Kazunari**
  **Kitamoto-shi**
  **Saitama 364-0022 (JP)**
• **MORI Hiroyuki**
  **Kitamoto-shi**
  **Saitama 364-0022 (JP)**
• **YAMASHITA Daiki**
  **Kitamoto-shi**
  **Saitama 364-0022 (JP)**

(74) Representative: **Hoffmann Eitle**
**Patent- und Rechtsanwälte PartmbB**
**Arabellastraße 30**
**81925 München (DE)**

(54) **COPPER ALLOY FOR ELECTRONIC OR ELECTRICAL DEVICE, COPPER ALLOY THIN SHEET FOR ELECTRONIC OR ELECTRICAL DEVICE, PROCESS FOR MANUFACTURING COPPER ALLOY FOR ELECTRONIC OR ELECTRICAL DEVICE, CONDUCTIVE COMPONENT FOR ELECTRONIC OR ELECTRICAL DEVICE, AND TERMINAL**

(57)     A copper alloy for an electric and electronic device includes more than 2.0 mass% to 36.5 mass% of Zn, 0.1 mass% to 0.9 mass% of Sn, 0.05 mass% to less than 1.0 mass% ofNi, 0.5 mass ppm to less than 10 mass ppm of Fe, 0.001 mass% to less than 0.10 mass% of Co, 0.001 mass% to 0.10 mass% of P, and a balance including Cu and unavoidable impurities, in which, ratios between the amounts of the respective elements satisfy $0.002 \leq Fe/Ni < 1.5$, $3 < (Ni+Fe)/P < 15$, and $0.3 < Sn/(Ni+Fe) < 5$ by atomic ratio, and the copper alloy includes a precipitate containing P and at least one element selected from the group consisting of Fe, Co and Ni.

FIG. 1

```
┌────────────────────┐
│    MELT            │── S01
│  CASTING STEP      │
└────────────────────┘
        │
┌────────────────────┐
│      INGOT         │
└────────────────────┘
        │
┌────────────────────┐
│   HEATING STEP     │── S02
└────────────────────┘
        │
┌────────────────────┐
│   HOT WORKING      │── S03
│      STEP          │
└────────────────────┘
        │
┌────────────────────┐
│ INTERMEDIATE PLASTIC│── S04
│   WORKING STEP     │
└────────────────────┘
        │
┌────────────────────┐
│ INTERMEDIATE HEAT  │── S05
│  TREATMENT STEP    │
└────────────────────┘
        │
┌────────────────────┐
│  FINISH PLASTIC    │── S06
│   WORKING STEP     │
└────────────────────┘
        │
┌────────────────────┐
│   FINISH HEAT      │── S07
│  TREATMENT STEP    │
└────────────────────┘
        │
┌────────────────────┐
│ COPPER ALLOY FOR ELECTRIC │
│  AND ELECTRONIC DEVICE    │
└────────────────────┘
```

EP 2 944 703 A1

**Description**

TECHNICAL FIELD

The present invention relates to a copper alloy, particularly, a Cu-Zn-Sn-based copper alloy for an electric and electronic device obtained by adding Sn to brass (Cu-Zn alloy), a copper alloy sheet for an electric and electronic device, a method of producing a copper alloy for an electric and electronic device, a conductive component for an electric and electronic device, and a terminal using the same, the copper alloy being used as a conductive component for an electric and electronic device such as a connector of a semiconductor device, other terminals thereof, a movable contact of an electromagnetic relay, or a lead frame.

Priority is claimed on Japanese Patent Application No. 2013-002112, filed January 9, 2013, the content of which is incorporated herein by reference.

BACKGROUND ART

As a material of a conductive component for an electric and electronic device such as terminals such as connectors in semiconductor devices, movable contact of electromagnetic relays, copper or a copper alloy is used and, among them, brass (Cu-Zn alloy) is widely used in the related art from the viewpoint of, for example, balance between strength, workability, and cost. In addition, in the case of a terminal such as a connector, mainly in order to improve reliability of contact with an opposite-side conductive member, it has become more frequent that a surface of a substrate (blank) formed of a Cu-Zn alloy is plated with tin (Sn).

In a conductive component such as a connector obtained by plating a surface of a Cu-Zn alloy as a substrate with Sn, a Cu-Zn-Sn-based alloy in which Sn as an alloy component added to the Cu-Zn alloy substrate may be used in order to improve the recycling efficiency of the Sn-plated substrate and the strength.

As a process for manufacturing an conductive component for an electric and electronic device such as a connector in a semiconductor, generally, it is common to produce a sheet (strip) having a thickness of about 0.05 mm to 1.0 mm by rolling a copper alloy as a raw material, obtain a predetermined shape by punching the sheet, and bend at least part of the sheet. In this case, it is common that the conductive component is brought into contact with an opposite-side conductive member near the bent portion so as to obtain electrical connection with the opposite-side conductive member and the contact state with the opposite-side conductive member is maintained due to the spring properties of the bent portion. In the above-described conductive component such as a connector, there is a desire for the copper alloy to have excellent conductivities to suppress heat generated by electrical resistance during electrical conduction, have high strength, and have excellent rollability or punching workability since the copper alloy is to be rolled to a sheet (strip) and be punched. Further, in the case of a connector or the like that is bent and is used so that the connection state with the opposite-side conductive member is maintained near the bent portion due to the spring properties of the bent portion, there is a demand for the copper alloy to have not only excellent bendability but also excellent stress relaxation resistance in order to favorably maintain the contact with the opposite-side conductive member near the bent portion for a long period of time (or even in a high-temperature atmosphere). That is, in a terminal such as a connector in which the connection state with an opposite-side conductive member is maintained using the spring properties of the bent portion, when the stress relaxation resistance is poor and thus residual stress at the bent portion is relaxed over time or residual stress at the bent portion is relaxed in a high-temperature operation environment, the contact pressure with the opposite-side conductive member is not sufficiently maintained and a problem of poor contact is likely to occur early.

As a method for improving the stress relaxation resistance of the Cu-Zn-Sn-based alloy that is used for a conductive component such as a connector, for example, proposals as described in Patent Documents 1 to 3 have thus far been made. Further, regarding a Cu-Zn-Sn-based alloy for a lead frame, Patent Document 4 also describes a method for improving stress relaxation resistance.

That is, first, Patent Document 1 describes that stress relaxation resistance can be improved by adding Ni to a Cu-Zn-Sn-based alloy to produce a Ni-P compound. In addition, Patent Document 1 describes that the addition of Fe is also efficient for improvement of stress relaxation resistance. Patent Document 2 describes that strength, elasticity, and heat resistance can be improved by adding Ni and Fe to a Cu-Zn-Sn-based alloy together with P to produce a compound. Although there is no direct description regarding stress relaxation resistance, it is considered that the improvement of strength, elasticity, and heat resistance refers to the improvement of stress relaxation resistance.

Although the present inventors have also confirmed that the addition of Ni, Fe, and P to a Cu-Zn-Sn-based alloy is effective for the improvement of stress relaxation resistance as described in the proposals of Patent Documents 1 and 2, the proposals of Patent Documents 1 and 2 take only the individual amounts of Ni, Fe, and P into account. It has been clarified by the present inventors through experiments and studies that stress relaxation resistance cannot be reliably and sufficiently improved at all times simply by the adjustment of the individual amounts thereof.

In the proposal of Patent Document 3, it is described that stress relaxation resistance can be improved by adding Ni to a Cu-Zn-Sn-based alloy and adjusting a Ni/Sn ratio to be in a specific range. In addition, Patent Document 3 describes that the addition of a small amount of Fe is also efficient for improving stress relaxation resistance.

Although the adjustment of the Ni/Sn ratio is also, surely, effective for the improvement of stress relaxation resistance as described in the proposal of Patent Document 3, it does not describe the relationship between a P compound and stress relaxation resistance. That is, the P compound is considered to have a great influence on stress relaxation resistance as described in Patent Documents 1 and 2. In the proposal of Patent Document 3, the relationship between the amounts of Fe, Ni, and the like which generate the P compound and stress relaxation resistance is not taken into account. Even in experiments by the present inventors, it has been clarified that stress relaxation resistance cannot be sufficiently and reliably improved simply by the proposal of Patent Document 3.

In addition, in the proposal of Patent Document 4 targeted for a lead frame, it is described that stress relaxation resistance can be improved by adding Ni and Fe to a Cu-Zn-Sn-based alloy together with P, adjusting an atomic ratio (Fe+Ni)/P to be in a range of 0.2 to 3, and producing a Fe-P-based compound, a Ni-P-based compound, or a Fe-Ni-P-based compound.

However, according to experiments by the present inventors, it has been clarified that stress relaxation resistance cannot be sufficiently improved simply by adjusting the total amounts of Fe, Ni, and P and the atomic ratio of (Fe+Ni)/P as regulated in Patent Document 4. The reasons therefore are not clear, but it has been clarified by the present inventors through experiments and studies that, in order to reliably and sufficiently improve stress relaxation resistance, not only the adjustment of the total amounts of Fe, Ni, and P and (Fe+Ni)/P but also the adjustment of the Fe/Ni ratio and Sn/(Ni+Fe) are important and stress relaxation resistance cannot be reliably and sufficiently improved until the ratios of the individual amounts thereof are adjusted in a well-balanced manner.

As described above, for a copper alloy which is made of a Cu-Zn-Sn-based alloy and used as a conductive component of an electric and electronic device, the proposals of the related art for improving stress relaxation resistance cannot be said to have a reliable and sufficient effect that improves stress relaxation resistance and there is a desire for additional improvement thereof. That is, in a component such as a connector which includes a bent portion obtained by rolling and bending a sheet (for example, a strip), is brought into contact with an opposite-side conductive member near the bent portion, and is used so as to maintain the contact state with an opposite-side conductive member due to the spring properties of the bent portion, residual stress is relaxed over time or in a high-temperature environment, and the contact pressure with an opposite-side conductive member is not maintained. As a result, there is a problem in that a problem such as contact failure is likely to occur in the early stages. In order to avoid such a problem, in the related art, the thickness of a material is inevitably increased. It results in an increase in material cost and weight.

Citation List

Patent Document

[Patent Document 1] Japanese Unexamined Patent Application, First Publication No. H5-33087
[Patent Document 2] Japanese Unexamined Patent Application, First Publication No. 2006-283060
[Patent Document 3] Japanese Patent No. 3953357
[Patent Document 4] Japanese Patent No. 3717321

DISCLOSURE OF INVENTION

Technical Problem

As described above, the Cu-Zn-Sn-based alloy in the related art which is used as a base material for a Sn-plated brass strip cannot be said to have reliable and sufficiently excellent stress relaxation resistance as a sheet material (strip) that is bent and is used so as to obtain contact with an opposite-side conductive member near the bent portion. Therefore, there is a strong demand for an additional reliable and sufficient improvement of stress relaxation resistance.

The present invention has been made in consideration of the above-described circumstances and an object of the present invention is to provide a copper alloy for an electric and electronic device, a copper alloy sheet for an electric and electronic device using the same, method of producing a copper alloy for an electric and electronic device, a conductive component for an electric and electronic device and a terminal, the copper alloy being used as a conductive component of an electric and electronic device such as a connector, other terminals, a movable contact in an electromagnetic relay, or a lead frame, particularly, having reliably and sufficiently excellent stress relaxation resistance as Cu-Zn-Sn-based alloy, being capable of having a smaller thickness as material of a component than the conventional alloy, having high strength, and having excellent characteristics such as bendability and conductivity.

Solution to Problem

As a result of repeating intensive experiments and studies regarding solutions to the above-described problems, the inventors have obtained the following findings. When an appropriate amount of nickel (Ni), iron (Fe), and cobalt (Co) are added at the same time to a Cu-Zn-Sn-based alloy, an appropriate amount of phosphorous (P) is added. Further, not only are each amount of the respective alloy elements adjusted, but the ratios between the amounts of Ni, Fe, Co, P, and Sn in the alloy, particularly, ratio (Fe+Co)/Ni of a total content of Fe and Co to a Ni content, a ratio (Ni+Fe+Co)/P of a total content (Ni+Fe+Co) of Ni, Fe, and Co to a P content, and a ratio Sn/(Ni+Fe+Co) of a Sn content to the total content (Ni+Fe+Co) of Ni, Fe, and Co are also adjusted to an appropriate range respectively by atomic ratio Thereby, precipitates containing P and at least one element selected from the group consisting of Fe, Co, and Ni are appropriately precipitated. As a result, stress relaxation resistance is reliably and sufficiently improved, strength is improved, and thus it is possible to obtain a copper alloy having excellent characteristics required for connectors, other terminals, movable contacts in electromagnetic relays, lead frames, or the like such as bendability and conductivity. In addition, Fe-based precipitates are reduced, and thereby the excessive refinement of crystal grains is suppressed and the relative degradation of stress relaxation resistance can be suppressed. The present invention has been made based on the above-described finding.

According to a first aspect of the present invention, there is provided a copper alloy for an electric and electronic device, the copper alloy comprising: more than 2.0 mass% to 36.5 mass% of Zn; 0.1 mass% to 0.9 mass% of Sn; 0.05 mass% to less than 1.0 mass% of Ni; 0.5 mass ppm to less than 10 mass ppm of Fe; 0.001 mass% to less than 0.10 mass% of Co; 0.001 mass% to 0.10 mass% of P; and a balance including Cu and unavoidable impurities, in which a ratio (Fe+Co)/Ni of a total content of Fe and Co to a Ni content satisfies $0.002 \leq (Fe+Co)/Ni < 1.5$ by atomic ratio, a ratio (Ni+Fe+Co)/P of a total content (Ni+Fe+Co) of Ni, Fe, and Co to a P content satisfies $3 < (Ni+Fe+Co)/P < 15$ by atomic ratio, a ratio Sn/(Ni+Fe+Co) of a Sn content to the total content (Ni+Fe+Co) of Ni, Fe, and Co satisfies $0.3 < Sn/(Ni+Fe+Co) < 5$ by atomic ratio, and the copper alloy includes precipitates containing P and at least one element selected from the group consisting of Fe, Co, and Ni.

According to the copper alloy for an electric and electronic device having the above-described constitution, since, in addition to an appropriate amount of Sn, an appropriate amount of Ni, Fe, and Co are added together with P and, furthermore, the addition ratios between Sn, Ni, Fe, Co, and P are appropriately controlled, it is possible to obtain a Cu-Zn-Sn-based alloy having a structure in which precipitates containing P and at least one element selected from the group consisting of Fe, Co and Ni, which is precipitated from a matrix (mainly composed of α phase), that is, [Ni, Fe, Co]-P-based precipitates are appropriately present. In addition, the [Ni, Fe, Co]-P-based precipitates are appropriately present and, at the same time, the amount of Fe is limited in a range of 0.5 mass ppm to less than 10 mass ppm so as to suppress the excessive refinement of crystal grains. Therefore, it is possible to obtain a Cu-Zn-Sn-based alloy which has reliable and sufficiently excellent stress relaxation resistance, has high strength (yield strength), and has excellent characteristics such as conductivity. When, simply, the individual amounts of Sn, Ni, Fe, Co, and P are adjusted to predetermined ranges, in actual materials, depending on the amounts of the elements, there are some cases in which stress relaxation resistance cannot be sufficiently improved or there are some cases in which other characteristics become insufficient. In the present invention, since the relative ratios between the amounts of the elements are limited within the range regulated by the expressions described above, it becomes possible to reliably and sufficiently improve the stress relaxation resistance of the copper alloy and, at the same time, provide satisfactory strength (yield strength).

Here, the [Ni,Fe,Co]-P-based precipitate refers to a quaternary precipitate of Ni-Fe-Co-P, a ternary precipitate of Ni-Fe-P, Ni-Co-P, or Fe-Co-P, or a binary precipitate of Fe-P, Ni-P, or Co-P and may include a multi-component precipitate containing the above-described elements and other elements, for example, major components such as Cu, Zn, and Sn and impurities such as O, S, C, Cr, Mo, Mn, Mg, Zr, and Ti. In addition, the [Ni,Fe,Co]-P-based precipitate is present in the form of a phosphide or an solid-solution alloy containing phosphorus.

According to a second aspect of the present invention, there is provided the copper alloy for an electric and electronic device according to the first aspect, in which an average grain size of the precipitates containing P and at least one element selected from the group consisting of Fe, Co and Ni is 100 nm or less.

Since the average grain size of the precipitates is controlled to 100 nm or less as described above, it is possible to more reliably improve stress relaxation resistance and also improve strength.

In addition, according to a third aspect of the present invention, there is provided the copper alloy for an electric and electronic device according to the second aspect, in which a precipitation density of the precipitates is 0.001% to 1.0% by volume fraction, the precipitation containing P and at least one element selected from the group of Fe, Co and Ni and having an average grain size of 100 nm or less.

In this case, since the precipitation density of the precipitates having an average grain size of 100 nm or less is adjusted to a range of 0.001% to 1.0% by volume fraction, it is possible to improve the stress relaxation resistance and strength of the copper alloy.

According to a fourth aspect of the present invention, there is provided the copper alloy for an electric and electronic device according to any one of the first to third aspects, in which the precipitates containing P and at least one element selected from the group consisting of Fe, Co and Ni have an $Fe_2P$-based, $Co_2P$-based, or $Ni_2P$-based crystal structure.

According to detailed experiments and studies by the present inventors, the above-described precipitate containing P and Fe, Co, or Ni is a hexagonal crystal (space group:P-62 m (189)) having a $Fe_2P$-based or $Ni_2P$-based crystal structure, or a orthorhombic crystal (space group:P-nma (62)) having a $Co_2P$-based or $Fe_2P$-based. In addition, it has been clarified that the presence of the precipitates having the above-described $Fe_2P$-based, $Co_2P$-based, or $Ni_2P$-based crystal structure contributes to the improvement of stress relaxation resistance and the improvement of strength through grain refinement.

In addition, according to a fifth aspect of the present invention, there is provided the copper alloy for an electric and electronic device according to any one of the first to fourth aspects, in which the copper alloy has mechanical properties including a 0.2% yield strength of 300 MPa or higher.

The copper alloy for an electric and electronic device, which has mechanical properties including the 0.2% yield strength of 300 MPa or higher, is suitable for a conductive component, for example, a movable contact of an electromagnetic relay or a spring portion of a terminal, in which high strength is particularly required.

According to a sixth aspect of the present invention, there is provided a copper alloy sheet for an electric and electronic device including: a sheet main body made of a rolled material formed of the copper alloy for an electric and electronic device according to any one of the first to fifth aspects, in which a thickness of the sheet main body is in a range of 0.05 mm to 1.0 mm. Note that, the copper alloy sheet main body may be a sheet (tape-shaped copper alloy) having a strip form.

The rolled sheet having the above-described thickness can be suitably used for a connector, other terminals, a movable contact of an electromagnetic relay, a lead frame, or the like.

Here, in the copper alloy sheet for an electric and electronic device according to the present invention, the surface may be plated with Sn. That is, the copper alloy sheet for an electric and electronic device according to a seventh aspect of the present invention is the copper alloy sheet for an electric and electronic device according to the sixth aspect further including an Sn-plated layer formed on a surface of the sheet main body. A single surface or both surfaces of the sheet main body may be plated with Sn.

In this case, a substrate to be plated with Sn is formed of a Cu-Zn-Sn-based alloy containing 0.1 mass% to 0.9 mass% of Sn. Therefore, a component such as a connector after use can be collected as scrap of a Sn-plated Cu-Zn-based alloy, and superior recycling efficiency can be secured.

In the copper alloy for an electric and electronic device according to the first to fifth aspects, or the sheet main body of the copper alloy sheet for an electric and electronic device according to the sixth or seventh aspect, a fraction of measurement points having a CI value of 0.1 or less may be 70% or less, when, for the $\alpha$ phase, a measurement using an EBSD method is performed at measurement intervals of 0.1 $\mu$m steps in a measurement area of 1000 $\mu m^2$ or more and an analysis is made using data analysis software OIM.

According to an eighth aspect of the present invention, there is provided a method of producing a copper alloy for an electric and electronic device, the method including: subjecting a raw material to at least one plastic-working and at least one heat treatment for recrystallization and precipitation to obtain a recrystallized sheet having a recrystallized structure and a predetermined sheet thickness; and subjecting the recrystallized sheet to a finish plastic-working at a working rate of 1% to 70% to obtain a copper alloy, in which the raw material is an alloy comprising: more than 2.0 mass% to 36.5 mass% ofZn; 0.1 mass% to 0.9 mass% of Sn; 0.05 mass% to less than 1.0 mass% of Ni; 0.5 mass ppm to less than 10 mass ppm of Fe; 0.001 mass% to less than 0.10 mass% of Co; 0.001 mass% to 0.10 mass% of P; and a balance including Cu and unavoidable impurities, in which a ratio (Fe+Co)/Ni of a total content of Fe and Co to a Ni content satisfies $0.002 \leq (Fe+Co)/Ni<1.5$ by atomic ratio, a ratio (Ni+Fe+Co)/P of a total content (Ni+Fe+Co) of Ni, Fe, and Co to a P content satisfies $3<(Ni+Fe+Co)/P<15$ by atomic ratio, and a ratio Sn/(Ni+Fe+Co) of a Sn content to the total content (Ni+Fe+Co) of Ni, Fe, and Co satisfies $0.3<Sn/(Ni+Fe+Co)<5$ by atomic ratio, in the copper alloy, a fraction of measurement points having a CI value of 0.1 or less is 70% or less, when, for the $\alpha$ phase, a measurement using an EBSD method is performed at measurement intervals of 0.1 $\mu$m steps in a measurement area of 1000 $\mu m^2$ or more and an analysis is made using data analysis software OIM, and the copper alloy includes precipitates containing P and at least one element selected from the group consisting of Fe, Ni, and Co.

The EBSD method refers to the electron backscatter diffraction patterns (EBSD) method in which an electron backscatter diffraction pattern system-attached scanning-type electron microscope is used. The OIM refers to data analysis software (Orientation Imaging Microscopy: OIM) for analyzing crystal orientations using measurement data obtained from EBSD. Further, the CI value refers to a confidence index which is a numerical value indicating the reliability of crystal orientation determination when an analysis is made using, for example, analysis software OIM Analysis (Ver. 5.3) in an EBSD device (for example, "EBSD guide: when using OIM (3rd revised edition)", Suzuki Seiichi, September 2009, published by TSL Solutions K.K.).

Here, in a case in which the structure of the measurement points measured using EBSD and analyzed through OIM is worked structure, the crystal patterns are not clear. Thus, the reliability of crystal orientation determination decreases, and, in this case, the CI value becomes low. Particularly, in a case in which the CI value is 0.1 or less, it is possible to determine that the structure of the measurement points is a worked structure. In addition, when the measurement points determined to have a worked structure with a CI value of 0.1 or less is 70% or less in a measurement area of 1000 $\mu m^2$ or more, it is possible to determine that the recrystallized structure is substantially maintained. In this case, it is possible to effectively prevent bendability from being impaired by the worked structure.

According to a ninth aspect of the present invention, there is provided the method of producing the copper alloy for an electric and electronic device according to the eighth aspect further including: low-temperature annealing in which the recrystallized sheet after the final plastic-working is heated at 50°C to 800°C for 0.1 seconds to 24 hours.

When the low-temperature annealing in which the recrystallized sheet is heated at 50°C to 800°C for 0.1 seconds to 24 hours is further performed after the finish plastic-working as described above, the stress relaxation resistance of the copper alloy is improved and it is possible to prevent deformation such as warping from occurring in the material due to strain remaining inside the material.

According to a tenth aspect of the present invention, there is provided a conductive component for an electric and electronic device including: the copper alloy for an electric and electronic device according to any one of the above-described first to fifth aspects.

According to an eleventh aspect of the present invention, there is provided a conductive component for an electric and electronic device including: the copper alloy sheet for an electric and electronic device according to the above-described sixth or seventh aspect.

Examples of the conductive component for an electric and electronic device according to the present invention include a terminal, a connector, a relay, a lead frame, and the like.

According to a twelfth aspect of the present invention, there is provided a terminal including: the copper alloy for an electric and electronic device according to any one of the above-described first to fifth aspects.

Further, according to a thirteenth aspect of the present invention, there is provided a terminal including: the copper alloy sheet for an electric and electronic device according to the above-described sixth or seventh aspect.

Examples of the terminal according to the present invention include connector.

According to the conductive component for an electric and electronic device and the terminal having the above-described configurations, stress relaxation resistance is superior. Therefore, residual stress is not likely to be relaxed over time or in a high-temperature environment. For example, when the conductive component and the terminal have a structure of coming into press contact with an opposite-side conductive member due to the spring properties of a bent portion, the contact pressure with the opposite-side conductive member can be maintained. In addition, the thickness of the conductive component for an electric and electronic device and terminal can be reduced.

Advantageous Effects of Invention

According to the present invention, it is possible to provide a copper alloy for an electric and electronic device, a copper alloy sheet for an electric and electronic device using the same, method of producing a copper alloy for an electric and electronic device, a conductive component for an electric and electronic device and a terminal, the copper alloy being used as a conductive component of an electric and electronic device such as a connector, other terminals, a movable contact in an electromagnetic relay, or a lead frame, particularly, having reliably and sufficiently excellent stress relaxation resistance as Cu-Zn-Sn-based alloy, being capable of having a smaller thickness as material of a component than the conventional alloy, having high strength, and, furthermore, having excellent characteristics such as bendability and conductivity.

BRIEF DESCRIPTION OF THE DRAWINGS

FIG. 1 is a flow chart showing a process example of a method of producing a copper alloy for an electric and electronic device according to the present invention.

FIG. 2 is a structure photograph obtained from a transmission electron microscopic (TEM) observation of an alloy of Example of the present invention No. 13, in which a portion including a precipitate is photographed at a magnification of 150,000 times.

FIG. 3 is a structure photograph obtained from the transmission electron microscopic (TEM) observation of the alloy of Example of the present invention No. 13, in which the portion including the precipitate is photographed at a magnification of 750,000 times.

DESCRIPTION OF EMBODIMENTS

Hereinafter, a copper alloy for an electric and electronic device according to the present invention will be described in more detail.

The copper alloy for an electric and electronic device of the present invention, basically, as the individual amounts of alloy elements, includes more than 2.0 mass% to 36.5 mass% of Zn, 0.1 mass% to 0.9 mass% of Sn, 0.05 mass% to less than 1.0 mass% of Ni, 0.5 mass ppm to less than 10 mass ppm of Fe, 0.001 mass% to less than 0.10 mass% of Co, and 0.001 mass% to 0.10 mass% of P. Content ratios between the respective alloy elements are determined such that a ratio (Fe+Co)/Ni of a total content of Fe and Co to a Ni content satisfies the following Expression (1) of $0.002 \leq (Fe+Co)/Ni < 1.5$ by atomic ratio, a ratio (Ni+Fe+Co)/P of a total content (Ni+Fe+Co) of Ni, Fe, and Co to a P content satisfies the following Expression (2) of $3 < (Ni+Fe+Co)/P < 15$ by atomic ratio, and a ratio Sn/(Ni+Fe+Co) of a Sn content to the total content (Ni+Fe+Co) of Ni, Fe, and Co satisfies the following Expression (3) of $0.3 < Sn/(Ni+Fe+Co) < 5$ by atomic ratio. The balance of the above-described alloy elements is Cu and unavoidable impurities. Further, as a structure condition, the copper alloy includes precipitates containing P and at least one element selected from Fe, Co and Ni. Hereinafter, the precipitate in this case will be referred to as the [Ni, Fe, Co]-P-based precipitate.

First, the reasons for limiting the component composition of the copper alloy of the present invention and the ratios between the alloy elements will be described.

Zinc (Zn): more than 2.0 mass% to 36.5 mass%

Zn is a basic alloy element in the copper alloy (brass), which is a target of the present invention and is an efficient element for improving strength and spring properties. In addition, Zn is cheaper than Cu and thus has an effect of reducing the material cost of the copper alloy. When the Zn content is 2 mass% or less, the effect of reducing the material cost cannot be sufficiently obtained. On the other hand, when the Zn content exceeds 36.5 mass%, the stress relaxation resistance of the copper alloy degrades, it becomes difficult to ensure sufficient stress relaxation resistance even when Fe, Ni, and P are added according to the present invention as described below, corrosion resistance degrades, and a large amount of a $\beta$ phase is produced. Therefore, cold rollability and bendability also degrade. Therefore, the Zn content is set to be in a range of more than 2.0 mass% to 36.5 mass%. In the above-described range, the Zn content is preferably in a range of 4.0 mass% to 36.5 mass%, more preferably in a range of 8.0 mass% to 32.0 mass%, and particularly preferably in a range of 8.0 mass% to 27.0 mass%.

Tin (Sn): 0.1 mass% to 0.9 mass%

Addition of Sn has an effect of improving strength. As a brass master alloy material for an electric and electronic device that is used after being plated with Sn, the addition of Sn is advantageous for improving the recycling efficiency of a Sn-plated brass material. Further, as a result of a study by the present inventors, it was found that the presence of Sn together with Ni and Fe contributes to the improvement of stress relaxation resistance. When the Sn content is less than 0.1 mass%, the above-described effects cannot be sufficiently obtained. On the other hand, when the Sn content is more than 0.9 mass%, hot workability and cold workability of the copper alloy decrease. Therefore, cracking may occur during hot rolling or cold rolling, and conductivity may decrease. Therefore, the Sn content is in a range of 0.1 mass% to 0.9 mass%. The Sn content is more preferably in a range of 0.2 mass% to 0.8 mass%.

Nickel (Ni): 0.05 mass% to less than 1.0 mass%

In the present invention, Ni is a characteristic addition element like Fe and P. By adding an appropriate amount of Ni to a Cu-Zn-Sn alloy so as to make Ni coexist with Fe, Co, and P, [Ni,Fe,Co]-P-based precipitates can be precipitated from a matrix (mainly composed of $\alpha$ phase). The presence of the above-described [Ni, Fe, Co]-P-based precipitates has an effect of pinning grain boundaries during recrystallization. As a result, the average grain size of the copper alloy can be reduced, and strength can be improved. The above-described decrease in the average grain size also enables the improvement of the bendability and stress corrosion cracking resistance of the copper alloy. Further, the presence of the above-described precipitates enables the significant improvement of stress relaxation resistance. In addition, the coexistence of Ni with Sn, Fe, Co, and P enables the improvement of stress relaxation resistance not only by the precipitates but also by solid solution strengthening. Here, when the addition amount of Ni is less than 0.05 mass%, stress relaxation resistance cannot be sufficiently improved. On the other hand, when the addition amount of Ni is 1.0 mass% or more, the amount of solid solution element Ni increases, and conductivity decreases. In addition, due to an increase in the amount of an expensive Ni material used, the cost increases. Therefore, in the embodiment, the Ni content is in a range of 0.05 mass% to less than 1.0 mass%. The Ni content is more preferably in a range of 0.05 mass% to less than 0.8 mass%.

Iron (Fe): 0.5 mass ppm to less than 10 mass ppm

Fe is a characteristic addition element in the present invention. By adding an appropriate amount of Fe to the Cu-Zn-Sn alloy so as to make Fe coexist with Ni, Co, and P, [Ni,Fe,Co]-P-based precipitates can be precipitated from a matrix (mainly composed of α phase). The presence of the above-described [Ni, Fe, Co]-P-based precipitates has an effect of pinning grain boundaries during recrystallization. As a result, the average grain size of the copper alloy can be made smaller, and strength can be improved. In addition, the above-described decrease in the average grain size also enables the improvement of the bendability and stress corrosion cracking resistance of the copper alloy. Further, the presence of the above-described precipitates enables the significant improvement of the stress relaxation resistance. Here, it is substantially difficult to manufacture the copper alloy in which the addition amount of Fe is less than 0.5 mass ppm. When the addition amount of Fe reaches 0.5 mass ppm or more, while some of Fe atoms constitute the precipitates, a majority of the Fe atoms form solid solution in the matrix and thus Fe contributes to solid solution strengthening. On the other hand, when the addition amount of Fe reaches 10 mass ppm or more, a large amount of Fe is included in the precipitates as a constituent thereof and the grain refinement effect of the precipitates becomes strong. As a result, work hardening performance becomes too strong and it is not possible to set a high rolling reduction. Therefore, it is necessary to repeat annealing and rolling multiple times until the copper alloy is worked to a predetermined thickness, which causes an increase in manufacturing costs.

Based on the above-described facts, the Fe content is set in a range of 0.5 mass ppm to less than 10 mass ppm.

Cobalt (Co): 0.001 mass% to less than 0.10 mass%

When Co is added together with Ni, Fe, and P, [Ni,Fe,Co]-P-based precipitates are produced, and stress relaxation resistance can be further improved. Here, when the addition amount of Co is less than 0.001 mass%, the effect of further improving stress relaxation resistance of the copper alloy obtained by the addition of Co cannot be obtained. On the other hand, when the addition amount of Co is 0.10 mass% or more, the amount of solid solution element Co increases, and conductivity of the copper alloy decreases. In addition, due to an increase in the amount of an expensive Co material used, the cost increases. Therefore, when Co is added, the Co content is in a range of 0.001 mass% to less than 0.10 mass%. The Co content is more preferably in a range of 0.002 mass% to 0.08 mass%.

Phosphorous (P): 0.005 mass% to 0.10 mass%

P has high bonding properties with Fe, Ni, and Co. When an appropriate amount of P is added together with Fe, Ni, and Co, [Ni,Fe,Co]-P-based precipitates can be precipitated. Due to the presence of the precipitates, stress relaxation resistance can be improved. When the P content is less than 0.005 mass%, it is difficult to precipitate a sufficient amount of the [Ni,Fe,Co]-P-based precipitates, and stress relaxation resistance cannot be sufficiently improved. On the other hand, when the P content exceeds 0.10 mass%, the amount of solid solution element P increases, conductivity of the copper alloy decreases, rollability decreases, and cold rolling cracking is likely to occur. Therefore, the P content is in a range of 0.005 mass% to 0.10 mass%. The P content is more preferably in a range of 0.01 mass% to 0.08 mass%.

P is an element which is likely to be unavoidably incorporated into molten raw materials of the copper alloy. Accordingly, in order to limit the P content to be as described above, it is desirable to appropriately select the molten raw materials.

Basically, the balance of the above-described elements may include Cu and unavoidable impurities. Examples of the unavoidable impurities include Mg, Al, Mn, Si, Cr, Ag, Ca, Sr, Ba, Sc, Y, Hf, V, Nb, Ta, Mo, W, Re, Ru, Os, Se, Te, Rh, Ir, Pd, Pt, Au, Cd, Ga, In, Li, Ge, As, Sb, Ti, Tl, Pb, Bi, S, O, C, Be, N, H, Hg, B, Zr, rare earth element, and the like. The total amount of the unavoidable impurities is preferably 0.3 mass% or less.

Further, in the copper alloy for an electric and electronic device according to the present invention, it is important not only to adjust each content of the alloy elements to be in the above-described range, but also to limit the ratios between the respective content of the elements such that the above-described Expressions (1) to (3) are satisfied by atomic ratio. Therefore, the reason for limiting the ratios to satisfy Expressions (1) to (3) will be described below.

$$\text{Expression (1): } 0.002 \leq (\text{Fe}+\text{Co})/\text{Ni} < 1.5$$

Fe, Co, and Ni are added to the copper alloy, the (Fe+Co)/Ni ratio has a significant influence on stress relaxation resistance. When the ratio is in a specific range, it is possible to sufficiently improve stress relaxation resistance. Therefore, it is found that sufficient improvement of stress relaxation resistance can be realized, in a case in which Ni, Fe, and Co are made to coexist, the individual amounts of Fe, Ni, and Co are adjusted as described above, and, furthermore, the ratio (Fe+Co)/Ni of the total content of Fe and Co to the Ni content is limited to be in a range of 0.002 to less than 1.5 by atomic ratio. Here, when the ratio (Fe+Co)/Ni is 1.5 or more, stress relaxation resistance decreases. When the ratio (Fe+Co)/Ni is less than 0.002, strength decreases. In addition, when the ratio (Fe+Co)/Ni is less than 0.002, the amount of an expensive Ni material used is relatively increased, which causes an increase in cost. Therefore, the ratio (Fe+Co)/Ni is limited to be in the above-described range. Even in the above-described range, the ratio (Fe+Co)/Ni is preferably in the range of 0.005 to 1. The ratio (Fe+Co)/Ni is more preferably in the range of 0.005 to 0.5.

## Expression (2): $3<(Ni+Fe+Co)/P<15$

When Ni, Fe, and Co coexist with P, the [Ni, Fe, Co]-P-based precipitates are produced and it is possible to improve stress relaxation resistance by the dispersion of the [Ni, Fe, Co]-P-based precipitates. On the other hand, when P is excessively included compared with (Ni+Fe+Co), stress relaxation resistance is, conversely, degraded due to an increase in the ratio of solid-solution element P. Therefore, in order to sufficiently improve stress relaxation resistance, the limitation of the (Ni+Fe+Co)/P ratio is also important. When the ratio (Ni+Fe+Co)/P is 3.0 or less, stress relaxation resistance of the copper alloy decreases along with an increase in the ratio of solid-solution element P. Concurrently, conductivity decreases due to the solid-solution element P, rollability decreases, and thus cold rolling cracking is likely to occur. Further, bendability decreases. On the other hand, when the ratio (Ni+Fe+Co)/P is 15 or more, conductivity decreases along with an increase in the ratio of solid-solution elements Ni, Fe and Co. Therefore, the ratio (Ni+Fe+Co)/P is limited to be in the above-described range. Note that, even in the above-described range, the (Ni+Fe+Co)/P ratio is, preferably set to be in a range of more than 3 to 12.

## Expression (3): $0.3<Sn/(Ni+Fe+Co)<5$

When coexisting with Ni, Fe, and Co, Sn contributes to the improvement of stress relaxation resistance. The effect of improving the stress relaxation resistance is not sufficiently exhibited unless the ratio Sn/(Ni+Fe+Co) is in a specific range. Specifically, when Sn/(Ni+Fe+Co) ratio is 0.3 or less, a sufficient effect of improving stress relaxation resistance is not exhibited. On the other hand, when the ratio Sn/(Ni+Fe+Co) is 5 or more, the (Ni+Fe+Co) content is relatively decreased, the amount of a [Ni,Fe,Co]-P-based precipitates decreases, and stress relaxation resistance of the copper alloy decreases. Note that, even in the above-described range, the Sn/(Ni+Fe+Co) ratio is preferably set to be in a range of more than 0.3 to 4.5, more preferably set to be in a range of more than 0.3 to 2.5, and particularly preferably set to be in a range of more than 0.3 to 1.5.

As described above, in the copper alloy for an electric and electronic device in which not only each content of the respective alloy elements but also the ratios between the elements are adjusted so as to satisfy Expressions (1) to (3), [Ni,Fe,Co]-P-based precipitates as described above are dispersed and precipitated from a matrix (mainly composed of $\alpha$ phase). It is presumed that, due to the dispersion and precipitation of the precipitates, stress relaxation resistance is improved.

In addition, in the copper alloy for an electric and electronic device of the present invention, it is preferable not only to adjust the component composition as described above but also to limit the average grain size of matrix ($\alpha$ phase) of the copper alloy in a range of 1 $\mu$m to 50 $\mu$m. It is known that stress relaxation resistance is also affected by the grain size of a material to a certain extent and, generally, stress relaxation resistance degrades as the grain size decreases. On the other hand, strength and bendability improve as the grain size decreases. In the case of the alloy of the present invention, since favorable stress relaxation resistance can be ensured by the appropriate adjustment of the component composition and the ratio between the respective amounts of alloy elements, it is possible to improve strength and bendability by decreasing the grain size. Here, when the average grain size is in a range of 1 $\mu$m to 50 $\mu$m in a stage after a finish heat treatment for recrystallization and precipitation in a producing process, it is possible to improve strength and bendability while ensuring stress relaxation resistance. When the average grain size exceeds 50 $\mu$m, it is not possible to obtain sufficient strength and bendability. On the other hand, when the average grain size is less than 1 $\mu$m, it becomes difficult to ensure stress relaxation resistance even when the component composition and the ratios between the respective amounts of alloy elements are appropriately adjusted. In order to improve stress relaxation resistance and the balance between strength and bendability, the average grain size is preferably in a range of 1 $\mu$m to 20 $\mu$m and more preferably in a range of 1 $\mu$m to 5 $\mu$m. Here, the average grain size refers to the average crystal grain size in the matrix of the alloy targeted in the present invention, the matrix being the $\alpha$ phase containing Cu as a main component and in which Zn and Sn are solid soluted.

Further, in the copper alloy for an electric and electronic device according to the present invention, the presence of the [Ni,Fe,Co]-P-based precipitates is important. As a result of a study by the present inventors, it was found that the precipitates are a hexagonal crystal (space group:P-62 m (189)) having a $Fe_2P$-based or $Ni_2P$-based crystal structure, or orthorhombic crystal (space group:P-nma (62)) having a $Co_2P$-based or $Fe_2P$-based. It is preferable that the precipitates have a fine average grain size of 100 nm or less. Due to the presence of the precipitates having a fine grain size, superior stress relaxation resistance can be secured, and strength and bendability can be improved through grain refinement. Here, when the average grain size of the precipitates exceeds 100 nm, contribution to the improvement of strength and stress relaxation resistance decreases.

Further, in the copper alloy for an electric and electronic device of the present invention, the fraction of the fine precipitates having an average grain size of 100 nm or less is preferably in a range of 0.001% to 1% by volume fraction. When the volume fraction of the fine precipitates having an average grain size of 100 nm or less is less than 0.001%, it becomes difficult to ensure favorable stress relaxation resistance in the copper alloy, and an effect that improves strength and bendability also cannot be sufficiently obtained. On the other hand, when the volume fraction thereof exceeds 1%, the bendability of the copper alloy degrades. The fraction of the fine precipitates having an average grain size of 100 nm or less is preferably in a range of 0.005% to 0.5% and more preferably in a range of 0.01% to 0.3% by volume fraction.

Further, in the copper alloy for an electric and electronic device of the present invention, a fraction of measurement points having a CI value of 0.1 or less is 70% or less, when, for the crystal grains in the α phase containing Cu, Zn and Sn, a measurement using an EBSD method is performed at measurement intervals of 0.1 μm steps in a measurement area of 1000 μm² or more and an analysis is made using data analysis software OIM. The reasons therefore are as described below.

As a treatment for improving the yield strength of the copper alloy as a product, it is preferable to carry out finish plastic working in the end, as described below in the description of the producing process. The finish plastic working is a treatment for improving the yield strength of the copper alloy as a product. The working method for the finish plastic working is not particularly limited. In a case in which the shape of the final product is in a plate or a strip, it is common to apply rolling. In addition, in a case in which the finish plastic working is carried out through rolling, crystal grains deform so as to elongate in a direction parallel to the rolling direction.

The confidence index (CI value) when an analysis is made using analysis software OIM in the EBSD device becomes a small value in a case in which the crystal pattern of the measurement points is not clear. When the CI value is 0.1 or less, it is possible to consider that the measurement point has a worked structure. In addition, in a case in which the fraction of measurement points at which the CI value is 0.1 or less is 70% or less, the recrystallized structure is substantially maintained, and bendability is not impaired.

In a case in which rolling is carried out as the finish plastic working, a surface (vertical surface) perpendicular to the rolling width direction, that is, the transverse direction (TD) surface, is used as the measurement surface by the EBSD method. In a case in which the finish plastic working is carried out using a method other than rolling, according to the TD surface in the case of rolling, a vertical surface along the main working direction may be used as the measurement surface.

In a case in which the copper alloy is worked so that the fraction of measurement points having the CI value of 0.1 or less exceeds 70%, strain introduced during working becomes too great, and thus there is a concern that bendability may be impaired.

A component made of the copper alloy of the present invention, for example, the copper alloy sheet for an electric and electronic device of the present invention can have a characteristic defined by the CI value regarding the crystal grains of the matrix (α phase).

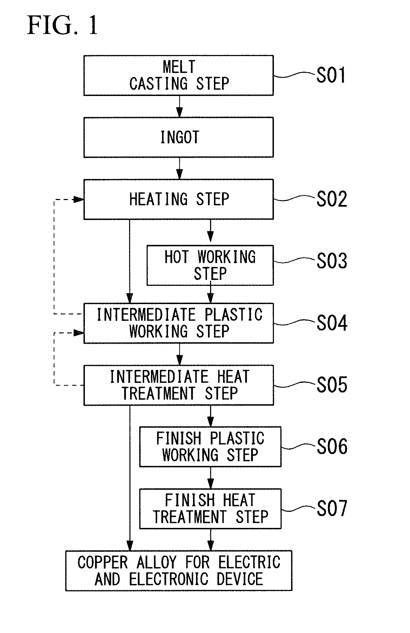

Next, a preferable example of a method of producing the above-described copper alloy for an electric and electronic device according to the embodiment will be described with reference to a flowchart shown FIG. 1.

[Melt Casting Step: S01]

First, molten copper alloy having the above-described component composition is prepared. As a copper material among melting raw materials, so-called 4NCu (for example, oxygen-free copper) having a purity of 99.99 % or higher is preferably used, and scrap may also be used as the material. In addition, in melting step, an air atmosphere furnace may be used. However, in order to suppress oxidation of Zn, vacuum furnace or an atmosphere furnace having an inert gas atmosphere or a reducing atmosphere may be used.

Next, the molten copper alloy with the components adjusted is cast into an ingot (a slab-shaped ingot or the like) using an appropriate casting method such as a batch type casting method (for example, metal mold casting), a continuous casting method, or a semi-continuous casting method.

[Heating step: S02]

Next, optionally, as a heating step S02 for the ingot, a homogenization heat treatment is performed as necessary to eliminate segregation of the ingot and homogenize the ingot structure. The conditions of the homogenization heat treatment are not particularly limited. Typically, heating may be performed at 600°C to 950°C for 5 minutes to 24 hours. When the homogenization heat treatment temperature is lower than 600°C or when the homogenization heat treatment time is shorter than 5 minutes, a sufficient effect of homogenizing may not be obtained. On the other hand, when the homogenization heat treatment temperature exceeds 950°C, a segregated portion may be partially melted. When the homogenization heat treatment time exceeds 24 hours, the cost increases. Cooling conditions after the homogenization heat treatment may be appropriately determined. Typically, water quenching may be performed. After the homogenization heat treatment, surface polishing may be performed as necessary.

[Hot Working: S03]

Next, hot working may be performed on the ingot to optimize rough processing and homogenize the structure after the above-described heating step S02. Hot working conditions are not particularly limited. Typically, it is preferable that the start temperature is 600°C to 950°C, the end temperature is 300°C to 850°C, and the working ratio is about 10% to 99%. Until the start temperature of the hot working, ingot heating may be performed as the above-described heating step S02. That is, the hot working may be started in a state in which the ingot is cooled to the hot working start temperature instead of cooling the ingot to near room temperature after the homogenization treatment. Cooling conditions after the hot working may be appropriately determined. Typically, water quenching may be performed. After the hot working, surface polishing may be performed as necessary. A working method of the hot working is not particularly limited. In a case in which the final shape of the product is a plate or a strip, hot rolling may be applied so that the ingot is rolled to a sheet thickness in a range of about 0.5 mm to 50 mm. In addition, in a case in which the final shape of the product is a wire or a rod, extrusion or groove rolling may be applied. Further, in a case in which the final shape of the product is a bulk shape, forging or pressing may be applied.

[Intermediate Plastic Working: S04]

Next, intermediate plastic working is performed on the ingot which undergoes the homogenization heat treatment in the heating step S02 as described above or the hot working material which undergoes the hot working (S03) such as hot rolling as necessary. In the intermediate plastic working S04, temperature conditions are not particularly limited and are preferably in a range of -200°C to +200°C of a cold or warm working temperature. The working ratio of the intermediate plastic working is not particularly limited and is typically about 10% to 99%. A working method is not particularly limited. In a case in which the final shape of the product is a plate or a strip, rolling may be applied so that the ingot is cold or warm-rolled to a sheet thickness in a range of about 0.05 mm to 25 mm. In addition, in a case in which the final shape of the product is a wire or a rod, extrusion or groove rolling may be applied. Further, in a case in which the final shape of the product is a bulk shape, forging or pressing may be applied. S02 to S04 may be repeated to strictly perform solutionizing.

[Intermediate Heat Treatment Step: S05]

After the intermediate plastic working (S04) at a cold or warm working temperature, for example, cold rolling, an intermediate heat treatment is performed as a recrystallization treatment and a precipitation treatment. This intermediate heat treatment is important not only to recrystallize the structure but also to disperse and precipitate a [Ni,Fe,Co]-P-based precipitates. Conditions of the heating temperature and the heating time may be adopted to produce the precipitates. Typically, the conditions may be 200°C to 800°C and 1 second to 24 hours. However, the grain size affects stress relaxation resistance to some extent as already described. Therefore, it is preferable that the grain size of crystal grains recrystallized by the intermediate heat treatment is measured to appropriately select conditions of the heating temperature and the heating time. The intermediate heat treatment and the subsequent cooling affect the final average grain size. Therefore, it is preferable that the conditions are selected such that the average grain size of the $\alpha$ phase is in a range of 1 $\mu$m to 50 $\mu$m.

The preferred heating temperature and heating time of the intermediate heat treatment vary depending on the specific method of the heat treatment as described below.

That is, as a specific method of the intermediate heat treatment, a method using a batch type heating furnace or a continuous heating method using a continuous annealing line may be used. Regarding the preferred heating conditions for the intermediate heat treatment, when the batch type heating furnace is used, it is preferable that heating is performed at a temperature of 300°C to 800°C for 5 minutes to 24 hours. In addition, when the continuous annealing line is used, it is preferable that the heating maximum temperature is set as 250°C to 800°C, and the temperature is not kept or only kept for about 1 second to 5 minutes in the above temperature range. In addition, it is preferable that the atmosphere of the intermediate heat treatment is a non-oxidizing atmosphere (nitrogen gas atmosphere, inert gas atmosphere, or reducing atmosphere).

Cooling conditions after the intermediate heat treatment are not particularly limited. Typically, cooling may be performed at a cooling rate of 2000 °C/sec to 100 °C/h.

Optionally, the intermediate plastic working S04 and the intermediate heat treatment S05 may be repeated multiple times. That is, for example, it is possible to carry out primary cold rolling as the first intermediate plastic working, carry out the first intermediate heat treatment, carry out secondary cold rolling as the second intermediate plastic working, and then carry out the second intermediate heat treatment.

[Finish Plastic Working: S06]

After the intermediate heat treatment step S05, finish working of the copper alloy is performed to obtain a copper alloy having a final dimension (thickness, width, and length) and a final shape. The working method for the finish plastic working is not particularly limited. In a case in which the shape of the final product of the copper alloy is in a plate or a strip, it is common to apply rolling (cold rolling). In this case, the ingot may be rolled to a sheet thickness in a range of 0.05 mm to 1.0 mm. In addition, depending on the shape of the final product, forging, pressing, groove rolling, or the like may be applied. The working ratio may be appropriately selected according to the final thickness and the final shape, and is preferably in a range of 1% to 70%. When the working ratio is less than 1%, an effect of improving yield strength cannot be sufficiently obtained. On the other hand, when the working ratio exceeds 70%, the recrystallized structure is substantially lost, and a so-called worked structure is obtained. As a result, bendability may decrease. The working ratio is preferably 1% to 65% and more preferably 5% to 60%. Here, in a case in which rolling is carried out as the finish plastic working, the rolling reduction corresponds to the working rate. After finish plastic working, the resultant may be used as a product without any change for a connector or the like. However, typically, it is preferable that finish heat treatment is further performed.

(Finish heat treatment step: S07)

After the finish plastic working, optionally, a finish heat treatment step S07 is performed to improve stress relaxation resistance and perform low-temperature annealing curing or to remove residual strain. It is preferable that this finish heat treatment is performed in a temperature range of 50°C to 800°C for 0.1 seconds to 24 hours. When the finish heat treatment temperature is lower than 50°C or when the finish heat treatment time is shorter than 0.1 seconds, a sufficient straightening effect may not be obtained. On the other hand, when the finish heat treatment temperature exceeds 800°C, recrystallization may occur. When the finish heat treatment time exceeds 24 hours, the cost will increase. When the finish plastic working S06 is not performed, the finish heat treatment step S07 can be omitted from the method of producing the copper alloy.

In the above-described manner, it is possible to obtain a Cu-Zn-Sn-based alloy material having a final product form in which the [Ni, Fe, Co]-P-based precipitates are dispersed and precipitated from the matrix mainly composed of $\alpha$ phase. Particularly, in a case in which rolling is applied as the working method, it is possible to obtain a Cu-Zn-Sn-based alloy sheet (strip) having a sheet thickness in a range of about 0.05 mm to 1.0 mm. The above-described sheet may be used for a conductive component for an electric and electronic device without any change. It is usual to plate either or both surfaces of the sheet with Sn to a film thickness in a range of about 0.1 mm to 10 $\mu$m, and use the sheet for a conductive component for an electric and electronic device such as a connector and other terminals in a form of a Sn-plated copper alloy strip. In this case, the Sn plating method is not particularly limited. Electrolytic plating may be applied according to an ordinary method, or a reflow treatment may be carried out after electrolytic plating depending on the case.

As described above, when the copper alloy for an electric and electronic device of the present invention is actually used for a connector or other terminals, there are many cases in which bending is carried out on a sheet or the like. It is common to bring the sheet or the like into press contact with an opposite-side conductive member due to the spring properties of the bent portion near the bent portion and use the sheet or the like in an aspect in which an electric connection with the opposite-side conductive member is ensured. The copper alloy of the present invention is optimal for use in the above-described aspect.

Hereinafter, the results of an experiment which were performed in order to verify the effects of the present invention will be shown as Examples of the present invention together with Comparative Examples. The following Examples are to describe the effects of the present invention, and configurations, processes, and conditions described in Examples do not limit the technical scope of the present invention.

EXAMPLES

First, as the melt casting step S01, a raw material made up of a Cu-40% Zn master alloy and oxygen-free copper (ASTM B152 C10100) with a purity of 99.99 mass% or more was prepared. Then, these materials were set in a crucible made of high purity graphite and melted using an electric furnace in a $N_2$ gas atmosphere. A various elements were added into the molten copper alloy, thereby molten alloys having component compositions of Nos. 1 to 58 shown in Tables 1 to 3 as Examples of the present invention and Nos. 101 to 105 shown in Table 4 as Comparative Examples, were prepared and were poured into carbon molds to prepare ingots. The size of the ingots was about 40 mm (thickness)×about 50 mm (width)×about 200 mm (length).

Next, each ingot was subjected to a homogenization treatment (heating step S02), in which the ingots were held in an Ar gas atmosphere at 800°C for a predetermined amount of time and then were water-quenched.

Next, hot rolling was performed as the hot working S03. Each of the ingots was reheated such that the hot rolling start temperature was 800°C, was hot-rolled at a rolling reduction of 50% such that a width direction of the ingot was a rolling direction, and was water-quenched such that the rolling end temperature was 300°C to 700°C. Next, the ingot was cut, and surface polishing was performed. As a result, a hot-rolled material having a size of about 16 mm (thickness)×about 160 mm (width)×about 100 mm (length).

Next, the intermediate plastic working S04 and the intermediate heat treatment step S05 were performed once or were repeatedly performed twice. That is, for Nos. 1, 5 to 42, 45, 47, 48, and 102 in Tables 5 to 8, primary cold rolling was carried out as primary intermediate plastic working, a secondary intermediate heat treatment was carried out, secondary cold rolling was carried out as secondary intermediate plastic working, and then a secondary intermediate heat treatment was carried out. On the other hand, for Nos. 2 to 4, 43, 44, 46, 49 to 58, 101, and 103 to 105, primary cold rolling was carried out as primary intermediate plastic working, and then a primary intermediate heat treatment was carried out. A secondary intermediate plastic working (secondary cold rolling) and a secondary intermediate heat treatment were not carried out.

Specifically, for Nos. 2 to 4, 43, 44, 46, 49 to 58, 101, and 103 to 105, primary cold rolling (primary intermediate plastic working) was performed at a rolling reduction of 90% or more. Next, as a primary intermediate heat treatment for recrystallization and precipitation treatment, a heat treatment was performed at 200°C to 800°C for a predetermined amount of time, and then water quenching was performed. After the primary intermediate heat treatment to water quenching, the rolled material was cut, and surface polishing was performed to remove an oxide film. Then, the rolled material was subjected to finish plastic working described below.

For Nos. 1, 5 to 42, 45, 47, 48, and 102, primary cold rolling (primary intermediate plastic working) was performed at a rolling reduction of about 50% to 95%. Next, as a primary intermediate heat treatment, a heat treatment was performed at 200°C to 800°C for a predetermined amount of time, and water quenching was performed. After that, secondary cold rolling (secondary intermediate plastic working) was performed at a rolling reduction of about 50% to 95%, a secondary intermediate heat treatment was performed at 200°C to 800°C for a predetermined amount of time so that the average grain size reached about 10 $\mu$m or less after the heat treatment, and then water quenching was performed. After the secondary intermediate heat treatment to the water quenching, the rolled material was cut, and surface polishing was performed to remove an oxide film. Then, the rolled material was subjected to finish plastic working described below.

In a stage after the primary or secondary intermediate heat treatment, the average grain size was investigated as described below.

When the average grain size exceeded 10 $\mu$m, for individual specimens, a surface perpendicular to the normal direction of a rolling surface, that is, a ND (Normal Direction) surface was used as an observation surface. The ND surface was mirror-polished and etched, was imaged using an optical microscope such that the rolling direction was a horizontal direction of an image, and was observed in a visual field (about 300x200 $\mu$m$^2$) of 1000 times. In order to obtain the grain size, five line segments having predetermined horizontal and vertical lengths were drawn in the image according to a cutting method of JIS H 0501, the number of crystal grains which were completely cut was counted, and the average value of the cut lengths thereof was calculated as the average grain size.

When the average grain size was 10 $\mu$m or less, a surface perpendicular to the width direction of rolling, that is, the TD surface, was used as an observation surface. The average grain size was measured using a SEM-EBSD (electron backscatter diffraction patterns) measurement device. Specifically, mechanical polishing was performed using waterproof abrasive paper and diamond abrasive grains, and finish polishing was performed using a colloidal silica solution. After that, individual measurement points (pixels) in a measurement range on a specimen surface were irradiated with an electron beam using a scanning electron microscope. Through an orientation analysis by electron backscatter diffraction, the high-angle grain boundary had an orientation difference of 15° or more between adjacent measurement points, and the low-angle grain boundary had an orientation difference of 15° or less between adjacent measurement points. Using the high-angle grain boundary, a grain boundary map was created. Five line segments having predetermined horizontal and vertical lengths were drawn in the map according to a cutting method of JIS H 0501, the number of crystal grains which were completely cut was counted, and the average value of the cut lengths thereof was calculated as the average grain size.

The average grain sizes in the stage after the primary intermediate heat treatment or the stage after the secondary intermediate heat treatment, which were investigated in the above-described manner, are described in Tables 5 to 8.

After that, finish rolling was performed at a rolling reduction as shown in Tables 5 to 8 as the finish plastic working S06.

Finally, a heat treatment was performed at 200°C to 350°C as the finish heat treatment S07, water quenching was performed, and cutting and surface-polishing were performed. As a result, a strip for characteristic evaluation having a size of 0.25 mm (thickness) $\times$ about 160 mm (width) was prepared.

Regarding the strip for characteristic evaluation, the conductivities and the mechanical properties (yield strength) and the stress relaxation resistances were evaluated, and, the structures were observed. Test methods and measurement methods for each evaluation item are as follows, and the results thereof are shown in Tables 9 to 12.

[Mechanical Properties]

A No. 13B specified in JIS Z 2201 was collected from the strip for characteristic evaluation, and the 0.2% yield strength $\sigma_{0.2}$ using an offset method according to JIS Z 2241. The specimen was collected such that a tensile direction of a tensile test was perpendicular to the rolling direction of the strip for characteristic evaluation.

[Conductivity]

A specimen having a size of 10 mm (width)x60 mm (length) was collected from the strip for characteristic evaluation, and the electrical resistance thereof was obtained using a four-terminal method. In addition, using a micrometer, the size of the specimen was measured, and the volume of the specimen was calculated. The conductivity was calculated from the measured electrical resistance and the volume. The specimen was collected such that a longitudinal direction thereof was parallel to the rolling direction of the strip for characteristic evaluation.

[Stress Relaxation Resistance]

In a stress relaxation resistance test, using a method specified in a cantilever screw method of JCBA (Japan Copper and Brass Association)-T309:2004, a stress was applied to the specimen, the specimen was held at a temperature of 120°C for a predetermined time, and then a residual stress ratio thereof was measured.

In the test method, a specimen (width: 10 mm) was collected from each of the strips for characteristic evaluation in a direction perpendicular to the rolling direction. An initial deflection displacement was set as 2 mm, and the span length was adjusted such that a surface maximum stress of the specimen was 80% of the yield strength. The surface maximum stress was determined from the following expression.

$$\text{Surface Maximum Stress (MPa)} = 1.5\ Et\delta_0/L_s^2$$

(wherein E: deflection coefficient (MPa), t: thickness of sample (t=0.25 mm), $\delta_0$: initial deflection displacement (2 mm), $L_s$: span length (mm))

The stress relaxation resistance was evaluated by measuring a residual stress ratio from a bending behavior after holding at a temperature of 120°C for 1000 h. The residual stress ratio was calculated using the following expression.

$$\text{Residual stress ratio (\%)} = (1 - \delta_t/\delta_0) \times 100$$

(wherein $\delta_t$: permanent deflection displacement (mm) after holding at 120°C for 1000 h - permanent deflection displacement (mm) after holding at room temperature for 24 h, $\delta_0$: initial deflection displacement (mm))

Regarding the evaluation of the stress relaxation resistance, for specimens having a Zn content of 2% to less than 20% (specimens described in the column of "2-20Zn evaluation" in Tables 9 to 12), specimens in which the residual stress ratio measured in the above-describe manner was 70% or more, were evaluated as favorable (A). Specimens having a residual stress ratio of less than 70% were evaluated as poor (B). In addition, for specimens having a Zn content of 20% to less than 36.5% (specimens described in the column of "20-36.5Zn evaluation" in Tables 9 to 12), specimens having a residual stress ratio of 60% or more were evaluated as favorable (A) and specimens having a residual stress ratio of less than 60% were evaluated to be poor (B).

[Grain Size Observation]

A surface perpendicular to the width direction of rolling, that is, a TD (transverse direction) surface was used as an observation surface. Using an EBSD measurement device and an OIM analysis software, grain boundaries and an orientation difference distribution were measured as described below.

Mechanical polishing was performed using waterproof abrasive paper and diamond abrasive grains, and finish polishing was performed using a colloidal silica solution. Using an EBSD measurement device (QUANTA FEG 450 manufactured by FEI Company, OIM DATA COLLECTION manufactured by EDAX/TSL (at present, AMETEK Inc.)) and an analysis software (OIM DATAANALYSIS Ver. 5.3 manufactured by EDAX/TSL (at present, AMETEK Inc.)), an orientation differences between crystal grains was analyzed under conditions of an acceleration voltage of electron beams of 20 kV, a measurement interval of 0.1 $\mu$m step, and a measurement area of 1000 $\mu m^2$ or more. The confidence index (CI) values of the measurement points were calculated from the analysis software OIM, and CI values of 0.1 or less were excluded by the analysis of the grain size. Grain boundaries were divided into a high-angle grain boundary and a low-angle grain boundary, in which, as a result of two-dimensional cross-sectional observation, the high-angle grain boundary had an orientation difference of 15° or more between two adjacent crystal grains, and the low-angle grain boundary had an orientation difference of 15° or less between two adjacent crystal grains. Using the high-angle grain boundary, a grain boundary map was created. Five line segments having predetermined horizontal and vertical lengths were drawn in the image according to a cutting method of JIS H 0501, the number of crystal grains which were completely cut was counted, and the average value of the cut lengths thereof was calculated as the average grain size.

In the present invention, the average grain diameter defines the crystal grains in $\alpha$ phase. In the above-described measurement of the average grain diameter, crystal grains in phases other than $\alpha$ phase, such as $\beta$ phase, rarely existed. When such grains existed, the grains were excluded in the calculation of the average grain diameter.

[Observation of Precipitates]

For each of the strips for characteristic evaluation, precipitates were observed as described below using transmission electron microscopes (TEM: H-800, HF-2000, and HF-2200 manufactured by Hitachi, Ltd., and JEM-2010F manufactured by JEOL, Ltd.) and an EDX analyzer (EDX analyzer Vantage manufactured by Noran Instruments).

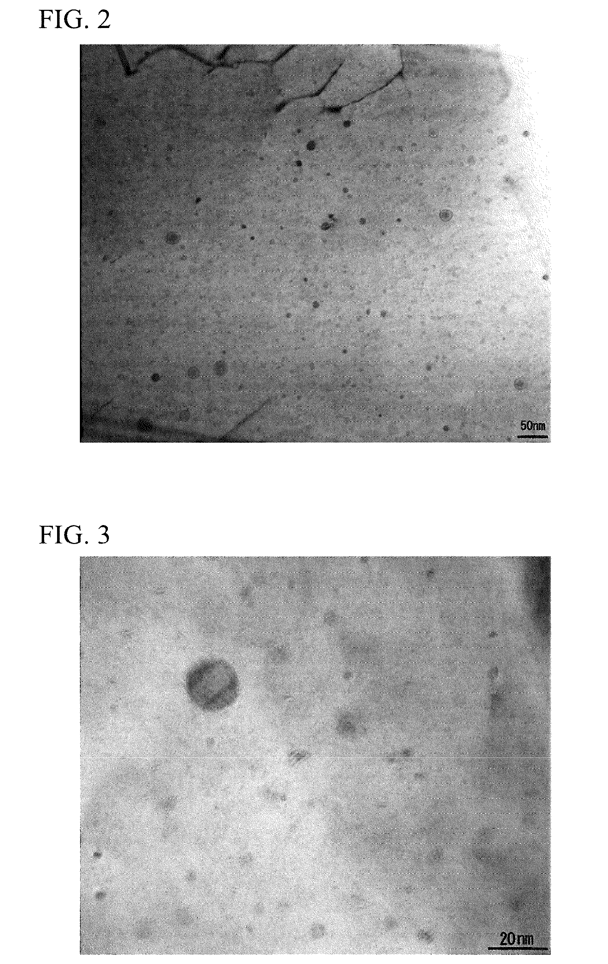

In Example of the present invention No. 13, precipitates having a grain size of 10 nm to 100 nm were observed at 150,000 times (an area of the observed visual field was about $4 \times 10^5$ nm$^2$) using a TEM (FIG. 2). In addition, precipitates having a grain size of 1 nm to 10 nm were observed at 750,000 times (an area of the observed visual field was about $2 \times 10^4$ nm$^2$) (FIG. 3).

Through the electron beam diffraction of the precipitates having a grain size of about 20 nm, it was confirmed that the precipitates were a hexagonal crystal having an $Fe_2P$-based or $Ni_2P$-based crystal structure or a $Co_2P$-based or $Fe_2P$-based orthorhombic crystal. Further, composition of the precipitates was analyzed through energy-dispersive X-ray spectroscopy (EDX). As a result it was confirmed that the precipitates contained Ni, Fe, Co, and P, that is, precipitates was the above-described [Ni,Fe,Co]-P-based precipitates.

[Volume Fraction of Precipitates]

The volume fraction of the precipitates was computed as described below.

First, the diameters of circles corresponding to precipitates having a grain size in a range of, mainly, 10 nm to 100 nm in a 150,000 times-magnified observed visual field, which is shown in FIG. 2, were obtained through an image treatment. The sizes and volumes of the respective precipitates were calculated from the obtained diameters. Next, the diameters of circles corresponding to the precipitates having a grain size in a range of, mainly, 1 nm to 10 nm in a 750,000 times-magnified observed visual field, which is shown in FIG. 3, were obtained through an image treatment. The sizes and volumes of the respective precipitates were calculated from the obtained diameters. In addition, the sum of volume fractions obtained from both results was obtained as the volume fraction of the precipitates having a grain size of 1 nm to 100 nm. In addition, film thicknesses of the specimens were measured using a contamination method. In the contamination method, a contamination was attached to a part of each specimen, and the thickness t of each specimen was calculated from an increase $\Delta L$ in the length of the contamination when the specimen was inclined by $\theta$, using the following expression.

$$t = \Delta L / \sin\theta$$

The volume of the observed visual field was calculated by multiplying the thickness t calculated as described above by the area of the observed visual field. The volume fraction was determined from a fraction of the sum of the volumes of the respective precipitates to the volume of the observed visual field.

As described in Table 13, in Example of the present invention No. 13, the volume fraction of the precipitates having a grain size of 10 nm to 100 nm (the volume fraction of the precipitates obtained from the observation at a magnification of 150,000 times) was 0.15%. The volume fraction of the precipitates having a grain size of 1 nm to 10 nm (the volume fraction of the precipitates obtained from the observation at a magnification of 750,000 times) was 0.07%. Therefore, the volume fraction of the precipitates having an $Fe_2P$-based, $Co_2P$-based, or $Ni_2P$-based crystal structure, having a grain size of 1 nm to 100 nm, and containing Fe, Co, Ni, and P was 0.22% in total. It was in the preferable range of the volume fraction (0.001% to 1.0%) in the present invention. In other Examples of the present invention No. 29,47, and 57 as well, the volume fractions of the precipitates were measured in the same manner, and all the volume fractions were in the desirable range of the volume fraction in the present invention as shown in Table 13.

[CI value]

Mechanical polishing was performed on the surface perpendicular to the width direction of rolling of the strip for characteristic evaluation, that is, the transverse direction (TD) surface, using waterproof abrasive paper and diamond abrasive grains, and finish polishing was performed using a colloidal silica solution. Using an EBSD measurement device (QUANTA FEG 450 manufactured by FEI Company, OIM DATA COLLECTION manufactured by EDAX/TSL (at present, AMETEK Inc.)) and an analysis software (OIM DATA ANALYSIS Ver. 5.3 manufactured by EDAX/TSL (at present, AMETEK Inc.)), an orientation differences between crystal grains was analyzed under conditions of an acceleration voltage of electron beams of 20 kV, a measurement interval of 0.1 $\mu$m step, and a measurement area of 1000 $\mu$m$^2$ or more. The confidence indexes (CI values) of the measurement points were calculated. After that, the fraction of measurement points having the CI value of 0.1 or less to the total measurement points was calculated. In the measurement, visual fields having no unique structure were selected from the respective strips, the fractions were calculated in 10 fields, and the average value thereof was used.

In the actual case, the measurement of the CI value was carried out together with the above-described [Grain Size Observation].

The structure observation results and the evaluation results are shown in Tables 9 to 12.

(Table 1)

| | [Examples of Present Invention] | | | | | | | | | |
|---|---|---|---|---|---|---|---|---|---|---|
| | Alloy Component Composition | | | | | | | Atomic Ratios of Alloy Elements | | |
| No. | Zn (mass%) | Sn (mass%) | Ni (mass%) | Co (mass%) | P (mass%) | Fe (mass ppm) | Cu | Atomic Ratio (Fe+Co)/Ni | Atomic Ratio (Ni+Fe+Co)/P | Atomic Ratio Sn/(Ni+Fe+Co) |
| 1 | 36.2 | 0.54 | 0.12 | 0.049 | 0.015 | 7 | Balance | 0.413 | 6.0 | 1.6 |
| 2 | 31.4 | 0.52 | 0.08 | 0.040 | 0.016 | 9 | Balance | 0.510 | 4.0 | 2.1 |
| 3 | 25.6 | 0.49 | 0.09 | 0.041 | 0.018 | 2 | Balance | 0.456 | 3.8 | 1.8 |
| 4 | 31.7 | 0.50 | 0.06 | 0.090 | 0.018 | 2 | Balance | 1.497 | 4.4 | 1.7 |
| 5 | 28.3 | 0.50 | 0.09 | 0.040 | 0.015 | 6 | Balance | 0.450 | 4.6 | 1.9 |
| 6 | 26.1 | 0.49 | 0.11 | 0.050 | 0.017 | 2 | Balance | 0.455 | 5.0 | 1.5 |
| 7 | 27.3 | 0.41 | 0.10 | 0.048 | 0.021 | 4 | Balance | 0.482 | 3.7 | 1.4 |
| 8 | 27.3 | 0.41 | 0.10 | 0.048 | 0.021 | 6 | Balance | 0.484 | 3.7 | 1.4 |
| 9 | 27.3 | 0.41 | 0.10 | 0.048 | 0.021 | 7 | Balance | 0.485 | 3.7 | 1.4 |
| 10 | 26.9 | 0.21 | 0.13 | 0.066 | 0.021 | 3 | Balance | 0.508 | 4.9 | 0.5 |
| 11 | 26.4 | 0.88 | 0.08 | 0.012 | 0.016 | 6 | Balance | 0.157 | 3.1 | 4.7 |
| 12 | 26.8 | 0.71 | 0.96 | 0.044 | 0.036 | 9 | Balance | 0.047 | 14.7 | 0.3 |
| 13 | 30.0 | 0.49 | 0.44 | 0.047 | 0.045 | 9 | Balance | 0.109 | 5.7 | 0.5 |
| 14 | 32.1 | 0.46 | 0.21 | 0.050 | 0.030 | 6 | Balance | 0.240 | 4.6 | 0.9 |
| 15 | 28.3 | 0.51 | 0.10 | 0.020 | 0.018 | 2 | Balance | 0.199 | 3.5 | 2.1 |
| 16 | 31.3 | 0.50 | 0.16 | 0.079 | 0.031 | 4 | Balance | 0.495 | 4.1 | 1.0 |
| 17 | 30.0 | 0.43 | 0.09 | 0.021 | 0.016 | 7 | Balance | 0.241 | 3.7 | 1.9 |
| 18 | 24.2 | 0.42 | 0.10 | 0.053 | 0.020 | 3 | Balance | 0.531 | 4.0 | 1.4 |
| 19 | 20.2 | 0.41 | 0.10 | 0.040 | 0.018 | 5 | Balance | 0.404 | 4.1 | 1.4 |

(Table 2)

| No. | Alloy Component Composition (mass%) | | | | | | | Atomic Ratios of Alloy Elements | | |
| --- | --- | --- | --- | --- | --- | --- | --- | --- | --- | --- |
| | Zn (mass%) | Sn (mass%) | Ni (mass%) | Co (mass%) | P (mass%) | Fe (mass ppm) | Cu | Atomic Ratio (Fe+Co)/Ni | Atomic Ratio (Ni+Fe+Co)/P | Atomic Ratio Sn/(Ni+Fe+Co) |
| 20 | 16.5 | 0.46 | 0.13 | 0.052 | 0.017 | 2 | Balance | 0.400 | 5.7 | 1.2 |
| 21 | 13.1 | 0.18 | 0.12 | 0.059 | 0.023 | 9 | Balance | 0.498 | 4.1 | 0.5 |
| 22 | 14.2 | 0.69 | 0.34 | 0.047 | 0.031 | 9 | Balance | 0.141 | 6.6 | 0.9 |
| 23 | 12.6 | 0.75 | 0.75 | 0.052 | 0.073 | 3 | Balance | 0.069 | 5.8 | 0.5 |
| 24 | 14.1 | 0.48 | 0.42 | 0.055 | 0.029 | 4 | Balance | 0.131 | 8.6 | 0.5 |
| 25 | 15.0 | 0.48 | 0.21 | 0.045 | 0.035 | 6 | Balance | 0.217 | 3.9 | 0.9 |
| 26 | 13.6 | 0.42 | 0.33 | 0.021 | 0.022 | 6 | Balance | 0.065 | 8.4 | 0.6 |
| 27 | 14.4 | 0.43 | 0.16 | 0.082 | 0.036 | 9 | Balance | 0.517 | 3.6 | 0.9 |
| 28 | 15.8 | 0.37 | 0.14 | 0.018 | 0.019 | 7 | Balance | 0.134 | 4.4 | 1.2 |
| 29 | 10.2 | 0.56 | 0.61 | 0.022 | 0.054 | 7 | Balance | 0.037 | 6.2 | 0.4 |
| 30 | 6.1 | 0.51 | 0.14 | 0.052 | 0.017 | 7 | Balance | 0.375 | 6.0 | 1.3 |
| 31 | 6.0 | 0.18 | 0.10 | 0.051 | 0.024 | 4 | Balance | 0.512 | 3.3 | 0.6 |
| 32 | 5.0 | 0.67 | 0.12 | 0.051 | 0.028 | 9 | Balance | 0.432 | 3.2 | 1.9 |
| 33 | 4.9 | 0.82 | 0.73 | 0.053 | 0.087 | 2 | Balance | 0.073 | 4.7 | 0.5 |
| 34 | 5.7 | 0.48 | 0.41 | 0.049 | 0.030 | 9 | Balance | 0.121 | 8.1 | 0.5 |
| 35 | 4.6 | 0.42 | 0.25 | 0.046 | 0.035 | 6 | Balance | 0.186 | 4.5 | 0.7 |
| 36 | 5.3 | 0.46 | 0.12 | 0.020 | 0.023 | 3 | Balance | 0.167 | 3.2 | 1.6 |
| 37 | 4.8 | 0.42 | 0.19 | 0.088 | 0.035 | 2 | Balance | 0.461 | 4.2 | 0.7 |
| 38 | 5.0 | 0.44 | 0.25 | 0.018 | 0.019 | 6 | Balance | 0.074 | 7.5 | 0.8 |
| 39 | 2.7 | 0.53 | 0.36 | 0.047 | 0.019 | 6 | Balance | 0.130 | 11.3 | 0.6 |

[Examples of Present Invention]

18

EP 2 944 703 A1

(Table 3)

| | | [Examples of Present Invention] | | | | | | | | |
|---|---|---|---|---|---|---|---|---|---|---|
| | Alloy Component Composition (mass%) | | | | | | | Atomic Ratios of Alloy Elements | | |
| No. | Zn (mass%) | Sn (mass%) | Ni (mass%) | Co (mass%) | P (mass%) | Fe (mass ppm) | Cu | Atomic Ratio (Fe+Co)/Ni | Atomic Ratio (Ni+Fe+Co)/P | Atomic Ratio Sn/(Ni+Fe+Co) |
| 40 | 28.8 | 0.59 | 0.60 | 0.036 | 0.073 | 3 | Balance | 0.060 | 4.6 | 0.5 |
| 41 | 21.2 | 0.70 | 0.67 | 0.012 | 0.055 | 7 | Balance | 0.019 | 6.6 | 0.5 |
| 42 | 17.5 | 0.39 | 0.60 | 0.008 | 0.057 | 2 | Balance | 0.013 | 5.6 | 0.3 |
| 43 | 7.3 | 0.56 | 0.46 | 0.019 | 0.037 | 4 | Balance | 0.042 | 6.8 | 0.6 |
| 44 | 8.1 | 0.46 | 0.60 | 0.003 | 0.065 | 7 | Balance | 0.006 | 4.9 | 0.4 |
| 45 | 9.4 | 0.74 | 0.94 | 0.049 | 0.048 | 3 | Balance | 0.052 | 10.9 | 0.4 |
| 46 | 3.4 | 0.59 | 0.65 | 0.010 | 0.051 | 7 | Balance | 0.016 | 6.8 | 0.4 |
| 47 | 23.6 | 0.62 | 0.62 | 0.005 | 0.048 | 2 | Balance | 0.008 | 6.9 | 0.5 |
| 48 | 13.2 | 0.55 | 0.51 | 0.003 | 0.055 | 4 | Balance | 0.007 | 4.9 | 0.5 |
| 49 | 7.2 | 0.59 | 0.54 | 0.004 | 0.041 | 1 | Balance | 0.007 | 7.0 | 0.5 |
| 50 | 3.5 | 0.55 | 0.61 | 0.002 | 0.047 | 6 | Balance | 0.004 | 6.9 | 0.4 |
| 51 | 6.7 | 0.56 | 0.54 | 0.002 | 0.047 | 5 | Balance | 0.005 | 6.1 | 0.5 |
| 52 | 5.2 | 0.89 | 0.52 | 0.001 | 0.048 | 6 | Balance | 0.003 | 5.7 | 0.8 |
| 53 | 7.1 | 0.57 | 0.59 | 0.002 | 0.044 | 4 | Balance | 0.004 | 7.1 | 0.5 |
| 54 | 6.5 | 0.54 | 0.56 | 0.002 | 0.052 | 2 | Balance | 0.004 | 5.7 | 0.5 |
| 55 | 12.1 | 0.51 | 0.56 | 0.002 | 0.055 | 2 | Balance | 0.004 | 5.4 | 0.4 |
| 56 | 11.4 | 0.51 | 0.54 | 0.003 | 0.047 | 5 | Balance | 0.006 | 6.1 | 0.5 |
| 57 | 8.9 | 0.59 | 0.61 | 0.021 | 0.043 | 2 | Balance | 0.035 | 7.7 | 0.5 |
| 58 | 9.1 | 0.61 | 0.55 | 0.012 | 0.048 | 5 | Balance | 0.023 | 6.2 | 0.5 |

(Table 4)

| No. | Alloy Component Composition (mass%) | | | | | | | Atomic Ratios of Alloy Elements | | |
| --- | --- | --- | --- | --- | --- | --- | --- | --- | --- | --- |
| | Zn (mass%) | Sn (mass%) | Ni (mass%) | Co (mass%) | P (mass%) | Fe (mass ppm) | Cu | Atomic Ratio (Fe+Co)/Ni | Atomic Ratio (Ni+Fe+Co)/P | Atomic Ratio Sn/(Ni+Fe+Co) |
| 101 | 37.2 | - | - | - | - | 6 | Balance | - | - | 0 |
| 102 | 35.9 | 0.88 | 0.96 | 0.044 | 0.091 | 1100 | Balance | 0.047 | 5.8 | 0.4 |
| 103 | 10.5 | - | 0.59 | 0.026 | - | 8 | Balance | 0.044 | - | 0 |
| 104 | 6.9 | 0.54 | - | 0.039 | - | 5 | Balance | - | - | 6.8 |
| 105 | 15.3 | 0.51 | 0.56 | - | - | 7 | Balance | 0 | - | 0.5 |

[Comparative Example]

(Table 5)

| | | | | [Examples of Present Invention] | | | |
|---|---|---|---|---|---|---|---|
| | | | | Steps | | | |
| | No. | Homogenization Temperature (°C) | Hot Rolling Start Temperature (°C) | Average Grain Size After Primary Intermediate Heat Treatment (μm) | Average Grain Size After Secondary Intermediate Heat Treatment (μm) | Finish Plastic-Working Rolling Reduction (%) | Finish Heat Treatment Temperature (°C) |
| | 1 | 800 | 800 | - | 3.9 | 31 | 300 |
| | 2 | 800 | 800 | 35.8 | - | 28 | 300 |
| | 3 | 800 | 800 | 16.7 | - | 34 | 325 |
| | 4 | 800 | 800 | 3.7 | - | 26 | 300 |
| | 5 | 800 | 800 | - | 3.1 | 24 | 300 |
| | 6 | 800 | 800 | - | 5.8 | 32 | 300 |
| | 7 | 800 | 800 | - | 2.9 | 33 | 350 |
| | 8 | 800 | 800 | - | 4.5 | 41 | 350 |
| | 9 | 800 | 800 | - | 3.3 | 55 | 350 |
| | 10 | 800 | 800 | - | 3.2 | 32 | 350 |
| | 11 | 800 | 800 | - | 3.9 | 29 | 350 |
| | 12 | 800 | 800 | - | 3.1 | 28 | 350 |
| | 13 | 800 | 800 | - | 2.9 | 29 | 350 |
| | 14 | 800 | 800 | - | 2.8 | 29 | 350 |
| | 15 | 800 | 800 | - | 3.9 | 26 | 350 |
| | 16 | 800 | 800 | - | 4.0 | 30 | 350 |
| | 17 | 800 | 800 | - | 3.5 | 26 | 350 |
| | 18 | 800 | 800 | - | 4.0 | 28 | 300 |
| | 19 | 800 | 800 | - | 3.6 | 32 | 300 |

(Table 6)

| | | | | [Examples of Present Invention] | | | |
|---|---|---|---|---|---|---|---|
| | | | | Steps | | | |
| | No. | Homogenization Temperature (°C) | Hot Rolling Start Temperature (°C) | Average Grain Size After Primary Intermediate Heat Treatment (μm) | Average Grain Size After Secondary Intermediate Heat Treatment (μm) | Finish Plastic-Working Rolling Reduction (%) | Finish Heat Treatment Temperature (°C) |
| | 20 | 800 | 800 | - | 3.0 | 34 | 275 |
| | 21 | 800 | 800 | - | 3.1 | 35 | 250 |
| | 22 | 800 | 800 | - | 3.6 | 32 | 250 |

(continued)

| | [Examples of Present Invention] | | | | | |
|---|---|---|---|---|---|---|
| | Steps | | | | | |
| No. | Homogenization Temperature (°C) | Hot Rolling Start Temperature (°C) | Average Grain Size After Primary Intermediate Heat Treatment (μm) | Average Grain Size After Secondary Intermediate Heat Treatment (μm) | Finish Plastic-Working Rolling Reduction (%) | Finish Heat Treatment Temperature (°C) |
| 23 | 800 | 800 | - | 4.5 | 34 | 250 |
| 24 | 800 | 800 | - | 3.1 | 36 | 250 |
| 25 | 800 | 800 | - | 2.6 | 36 | 250 |
| 26 | 800 | 800 | - | 3.0 | 37 | 250 |
| 27 | 800 | 800 | - | 2.8 | 35 | 250 |
| 28 | 800 | 800 | - | 2.9 | 32 | 250 |
| 29 | 800 | 800 | - | 3.4 | 45 | 275 |
| 30 | 800 | 800 | - | 4.1 | 44 | 250 |
| 31 | 800 | 800 | - | 4.9 | 45 | 275 |
| 32 | 800 | 800 | - | 4.2 | 42 | 250 |
| 33 | 800 | 800 | - | 4.4 | 47 | 275 |
| 34 | 800 | 800 | - | 4.3 | 44 | 250 |
| 35 | 800 | 800 | - | 3.5 | 42 | 250 |
| 36 | 800 | 800 | - | 5.0 | 41 | 250 |
| 37 | 800 | 800 | - | 4.2 | 45 | 250 |
| 38 | 800 | 800 | - | 4.4 | 40 | 250 |
| 39 | 800 | 800 | - | 4.3 | 45 | 200 |

(Table 7)

| | [Examples of Present Invention] | | | | | |
|---|---|---|---|---|---|---|
| | Steps | | | | | |
| No. | Homogenization Temperature (°C) | Hot Rolling Start Temperature (°C) | Average Grain Size After Primary Intermediate Heat Treatment (μm) | Average Grain Size After Secondary Intermediate Heat Treatment (μm) | Finish Plastic-Working Rolling Reduction (%) | Finish Heat Treatment Temperature (°C) |
| 40 | 800 | 800 | - | 3.1 | 57 | 300 |
| 41 | 800 | 800 | - | 4.2 | 59 | 325 |
| 42 | 800 | 800 | - | 3.5 | 55 | 300 |
| 43 | 800 | 800 | 4.2 | - | 51 | 300 |
| 44 | 800 | 800 | 4.5 | - | 49 | 300 |

(continued)

| No. | Homogenization Temperature (°C) | Hot Rolling Start Temperature (°C) | Average Grain Size After Primary Intermediate Heat Treatment (μm) | Average Grain Size After Secondary Intermediate Heat Treatment (μm) | Finish Plastic-Working Rolling Reduction (%) | Finish Heat Treatment Temperature (°C) |
|---|---|---|---|---|---|---|
| 45 | 800 | 800 | - | 3.7 | 52 | 300 |
| 46 | 800 | 800 | 5.0 | - | 53 | 300 |
| 47 | 800 | 800 | - | 5.1 | 55 | 325 |
| 48 | 800 | 800 | - | 4.0 | 55 | 325 |
| 49 | 800 | 800 | 3.9 | - | 53 | 300 |
| 50 | 800 | 800 | 4.5 | - | 56 | 325 |
| 51 | 800 | 800 | 3.7 | - | 51 | 350 |
| 52 | 800 | 800 | 4.7 | - | 52 | 350 |
| 53 | 800 | 800 | 4.8 | - | 51 | 350 |
| 54 | 800 | 800 | 5.7 | - | 62 | 350 |
| 55 | 800 | 800 | 4.3 | - | 50 | 350 |
| 56 | 800 | 800 | 4.0 | - | 48 | 350 |
| 57 | 800 | 800 | 4.9 | - | 53 | 350 |
| 58 | 800 | 800 | 5.2 | - | 53 | 350 |

*[Examples of Present Invention] — Steps*

(Table 8)

| No. | Homogenization Temperature (°C) | Hot Rolling Start Temperature (°C) | Average Grain Size After Primary Intermediate Heat Treatment (μm) | Average Grain Size After Secondary Intermediate Heat Treatment (μm) | Finish Plastic-Working Rolling Reduction (%) | Finish Heat Treatment Temperature (°C) |
|---|---|---|---|---|---|---|
| 101 | 800 | 800 | 8.9 | - | 21 | 350 |
| 102 | 800 | 800 | - | 2.5 | 59 | - |
| 103 | 800 | 800 | 4.8 | - | 45 | 350 |
| 104 | 800 | 800 | 5.7 | - | 56 | 350 |
| 105 | 800 | 800 | 4.3 | - | 48 | 350 |

*[Comparative Example] — Steps*

(Table 9)

| No. | Structure | | Evaluation | | | |
|---|---|---|---|---|---|---|
| | CI value (Fraction of 0.1 or less) (%) | Average Grain Size ($\mu$m) | Conductivity (%IACS) | Yield Strength (MPa) | Stress Relaxation Resistance | |
| | | | | | 2-20Zn Evaluation | 20-36.5Zn Evaluation |
| 1 | 32 | 2.9 | 24 | 609 | - | A |
| 2 | 26 | 26.0 | 25 | 479 | - | A |
| 3 | 34 | 11.3 | 24 | 513 | - | A |
| 4 | 24 | 2.8 | 25 | 563 | - | A |
| 5 | 23 | 2.5 | 24 | 568 | - | A |
| 6 | 32 | 4.3 | 25 | 578 | - | A |
| 7 | 33 | 2.1 | 25 | 621 | - | A |
| 8 | 44 | 3.0 | 24 | 675 | - | A |
| 9 | 64 | 2.4 | 24 | 722 | - | A |
| 10 | 31 | 2.4 | 25 | 592 | - | A |
| 11 | 30 | 3.0 | 22 | 562 | - | A |
| 12 | 26 | 2.4 | 22 | 609 | - | A |
| 13 | 27 | 2.3 | 23 | 592 | - | A |
| 14 | 30 | 2.2 | 23 | 607 | - | A |
| 15 | 24 | 3.1 | 24 | 578 | - | A |
| 16 | 28 | 3.1 | 24 | 610 | - | A |
| 17 | 23 | 2.8 | 24 | 571 | - | A |
| 18 | 25 | 3.1 | 25 | 594 | - | A |
| 19 | 32 | 2.7 | 28 | 565 | - | A |

(Table 10)

| No. | Structure | | Evaluation | | | |
|---|---|---|---|---|---|---|
| | CI value (Fraction of 0.1 or less) (%) | Average Grain Size ($\mu$m) | Conductivity (%IACS) | Yield Strength (MPa) | Stress Relaxation Resistance | |
| | | | | | 2-20Zn Evaluation | 20-36.5Zn Evaluation |
| 20 | 37 | 2.2 | 30 | 560 | A | - |
| 21 | 33 | 2.2 | 32 | 542 | A | - |
| 22 | 34 | 2.7 | 28 | 588 | A | - |
| 23 | 38 | 3.3 | 24 | 595 | A | - |
| 24 | 35 | 2.2 | 27 | 570 | A | - |
| 25 | 37 | 2.3 | 32 | 558 | A | - |
| 26 | 37 | 2.1 | 31 | 553 | A | - |

(continued)

| No. | Structure | | | Evaluation | | | |
|---|---|---|---|---|---|---|---|
| | CI value (Fraction of 0.1 or less) (%) | Average Grain Size (μm) | | Conductivity (%IACS) | Yield Strength (MPa) | Stress Relaxation Resistance | |
| | | | | | | 2-20Zn Evaluation | 20-36.5Zn Evaluation |
| 27 | 35 | 2.3 | | 29 | 587 | A | - |
| 28 | 31 | 2.1 | | 31 | 561 | A | - |
| 29 | 49 | 2.1 | | 30 | 524 | A | - |
| 30 | 45 | 2.7 | | 41 | 504 | A | - |
| 31 | 48 | 3.1 | | 45 | 483 | A | - |
| 32 | 47 | 2.8 | | 44 | 484 | A | - |
| 33 | 53 | 2.7 | | 33 | 504 | A | - |
| 34 | 46 | 2.8 | | 37 | 482 | A | - |
| 35 | 48 | 2.3 | | 45 | 477 | A | - |
| 36 | 44 | 3.3 | | 44 | 464 | A | - |
| 37 | 46 | 2.7 | | 45 | 501 | A | - |
| 38 | 42 | 2.9 | | 42 | 466 | A | - |
| 39 | 47 | 2.7 | | 46 | 434 | A | - |

(Table 11)

| No. | Structure | | | Evaluation | | | |
|---|---|---|---|---|---|---|---|
| | CI value (Fraction of 0.1 or less) (%) | Average Grain Size (μm) | | Conductivity (%IACS) | Yield Strength (MPa) | Stress Relaxation Resistance | |
| | | | | | | 2-20Zn Evaluation | 20-36.5Zn Evaluation |
| 40 | 61 | 2.2 | | 23 | 650 | - | A |
| 41 | 65 | 2.1 | | 23 | 634 | - | A |
| 42 | 57 | 2.3 | | 26 | 613 | A | - |
| 43 | 57 | 2.3 | | 35 | 553 | A | - |
| 44 | 44 | 2.5 | | 31 | 541 | A | - |
| 45 | 53 | 2.2 | | 27 | 599 | A | - |
| 46 | 49 | 2.6 | | 37 | 474 | A | - |
| 47 | 61 | 2.7 | | 23 | 605 | - | A |
| 48 | 60 | 2.5 | | 27 | 608 | A | - |
| 49 | 63 | 2.8 | | 32 | 594 | A | - |
| 50 | 65 | 2.3 | | 38 | 495 | A | - |
| 51 | 53 | 2.2 | | 35 | 530 | A | - |
| 52 | 46 | 2.5 | | 33 | 540 | A | - |

(continued)

| [Examples of Present Invention] | | | | | | |
|---|---|---|---|---|---|---|
| | Structure | | Evaluation | | | |
| No. | CI value (Fraction of 0.1 or less) (%) | Average Grain Size (μm) | Conductivity (%IACS) | Yield Strength (MPa) | Stress Relaxation Resistance | |
| | | | | | 2-20Zn Evaluation | 20-36.5Zn Evaluation |
| 53 | 57 | 2.6 | 35 | 521 | A | - |
| 54 | 68 | 2.5 | 35 | 520 | A | - |
| 55 | 56 | 2.6 | 31 | 569 | A | - |
| 56 | 48 | 2.9 | 31 | 572 | A | - |
| 57 | 50 | 2.6 | 32 | 540 | A | - |
| 58 | 53 | 3.1 | 32 | 545 | A | - |

(Table 12)

| [Comparative Example] | | | | | | |
|---|---|---|---|---|---|---|
| | Structure | | Evaluation | | | |
| No. | CI value (Fraction of 0.1 or less) (%) | Average Grain Size (μm) | Conductivity (%IACS) | Yield Strength (MPa) | Stress Relaxation Resistance | |
| | | | | | 2-20Zn Evaluation | 20-36.5Zn Evaluation |
| 101 | 46 | 6.2 | 26 | 502 | - | B |
| 102 | - | - | - | - | - | - |
| 103 | 51 | 2.8 | 35 | 480 | B | - |
| 104 | 60 | 2.6 | 37 | 451 | B | - |
| 105 | 56 | 2.9 | 28 | 524 | B | - |

(Table 13)

| No. | Volume Fraction of Precipitate | | Type |
|---|---|---|---|
| | 10 to 100 nm (150,000 times) | 1 to 100 nm (750,000 times) | |
| 13 | 0.15% | 0.07% | Examples of Present Invention |
| 29 | 0.17% | 0.08% | Examples of Present Invention |
| 47 | 0.18% | 0.09% | Examples of Present Invention |
| 57 | 0.17% | 0.08% | Examples of Present Invention |

The evaluation results of the respective specimens will be described below.

No. 1 was an Example of the present invention in which a Cu-35Zn alloy containing about 35% of Zn was based. Nos. 2,4 to 17, and 40 were Examples of the present invention in which a Cu-30Zn alloy containing about 30% of Zn was based. Nos. 3 and 18 were Examples of the present invention in which a Cu-25Zn alloy containing about 25% of Zn was based. Nos. 19 and 41 were Examples of the present invention in which a Cu-20Zn alloy containing about 20% of Zn was based. Nos. 20 to 28,42, and 48 were Examples of the present invention in which a Cu-15Zn alloy containing about 15% of Zn was based. Nos. 29 and 55 to 58 were Examples of the present invention in which a Cu-10Zn alloy containing about 10% of Zn was based. Nos. 30 to 38 and 51 to 54 were Examples of the present invention in which a Cu-5Zn alloy containing about 5% of Zn was based, Nos. 39 and 50 were Examples of the present invention in which a Cu-3Zn alloy containing about 3% of Zn was based. Nos. 43 to 45 were Examples of the present invention in which a Cu-5 to 10Zn alloy containing 5% to 10% of Zn was based. No. 46 was an Example of the present invention in which a Cu-3Zn alloy containing about 3% of Zn was based. No. 47 was an Example of the present invention in which a Cu-20 to 25Zn alloy containing 20% to 25% of Zn was based. No. 49 was an Example of the present invention in which a Cu-5 to 10Zn alloy containing 5% to 10% of Zn was based.

In addition, No. 101 was a Comparative Example in which the Zn content exceeded the upper limit of the range of the present invention. No. 102 was a Comparative Example which was a Cu-35Zn alloy containing about 35% of Zn and in which the Fe content exceeded the upper limit of the range of the present invention. No. 103 was a Comparative Example in which a Cu-10Zn alloy containing about 10% of Zn was based, No. 104 was a Comparative Example in which a Cu-5 to 10Zn alloy containing about 5% to 10% of Zn was based, and No. 105 was a Comparative Example in which a Cu-15Zn alloy containing about 15% of Zn was based.

As described in Tables 9 to 11, it was confirmed that all of the Examples of the present invention Nos. 1 to 58 in which the each amount of the respective alloy elements was in the ranges regulated by the present invention and the ratios between the respective alloy components were in the ranges regulated by the present invention, had excellent stress relaxation resistance, and had a conductivity of 20%IACS or more. Therefore, they could be sufficiently applied to connectors or other terminal members, and had a mechanical strength (yield strength) comparable or superior to conventional alloy.

As described in Table 12, in Comparative Examples No. 101 to 105, the stress relaxation resistance, the mechanical strength (yield strength), or the workability was poorer than the Examples of the present invention.

That is, in Comparative Example No. 101 of which the Zn content exceeded the upper limit of the present invention, the stress relaxation resistance was poor.

In Comparative Example No. 102 of which the Fe content exceeded the upper limit of the range of the present invention, cracking occurred in finish rolling with a rolling reduction of 59%. Therefore, the evaluations thereafter were stopped.

In Comparative Example No. 103 as the Cu-10Zn alloy to which Sn and P were not added, the yield strength was lower and the stress relaxation resistance poorer than those of the Cu-10Zn-based alloy of the Example of the present invention.

Comparative Example No. 104 as a Cu-5 to 10Zn-based alloy to which Ni and P were not added, the yield strength was lower and the stress relaxation resistance poorer than those of the Cu-10Zn-based alloy of the Example of the present invention.

Comparative Example No. 105 as a Cu-15Zn-based alloy to which Co and P were not added, the stress relaxation resistance poorer than that of the Cu-15Zn-based alloy of the Example of the present invention.

INDUSTRIAL APPLICABILITY

According to the present invention, it is possible to provide a copper alloy which can be easily decreased in thickness and has excellent characteristics such as strength, bendability, conductivity, and stress relaxation resistance. A conductive component for an electronic or electric device and a terminal made of the above-described copper alloy or a sheet made of the copper alloy, can maintain the contact pressure with an opposite-side conductive member for a long period of time and even in a high-temperature environment.

**Claims**

1.   A copper alloy for an electric and electronic device, comprising:

more than 2.0 mass% to 36.5 mass% of Zn;

0.1 mass% to 0.9 mass% of Sn;
0.05 mass% to less than 1.0 mass% of Ni;
0.5 mass ppm to less than 10 mass ppm of Fe;
0.001 mass% to less than 0.10 mass% of Co;
0.001 mass% to 0.10 mass% of P; and
a balance including Cu and unavoidable impurities,

wherein a ratio (Fe+Co)/Ni of a total content of Fe and Co to a Ni content satisfies $0.002 \leq (Fe+Co)/Ni < 1.5$ by atomic ratio,

a ratio (Ni+Fe+Co)/P of a total content (Ni+Fe+Co) of Ni, Fe, and Co to a P content satisfies 3<(Ni+Fe+Co)/P<15 by atomic ratio,

a ratio Sn/(Ni+Fe+Co) of a Sn content to the total content (Ni+Fe+Co) of Ni, Fe, and Co satisfies 0.3<Sn/(Ni+Fe+Co)<5 by atomic ratio, and

the copper alloy includes precipitates containing P and at least one element selected from the group consisting of Fe, Co, and Ni.

2. The copper alloy for an electric and electronic device according to claim 1,
wherein an average grain size of the precipitates containing P and at least one element selected from the group consisting of Fe, Co and Ni is 100 nm or less.

3. The copper alloy for electric and electronic device according to claim 2,
wherein a precipitation density of the precipitates is 0.001% to 1.0% by volume fraction, the precipitation containing P and at least one element selected from the group of Fe, Co and Ni and having an average grain size of 100 nm or less.

4. The copper alloy for an electric and electronic device according to any one of claims 1 to 3,
wherein the precipitates containing P and at least one element selected from the group consisting of Fe, Co and Ni have an $Fe_2P$-based, $Co_2P$-based, or $Ni_2P$-based crystal structure.

5. The copper alloy for an electric and electronic device according to any one of claims 1 to 3,
wherein the copper alloy has mechanical properties including a 0.2% yield strength of 300 MPa or higher.

6. A copper alloy sheet for an electric and electronic device, comprising:

a sheet main body made of a rolled material formed of the copper alloy for an electric and electronic device according to any one of claims 1 to 3,
wherein a thickness of the sheet main body is in a range of 0.05 mm to 1.0 mm.

7. The copper alloy sheet for an electric and electronic device according to claim 6, further comprising:

an Sn-plated layer formed on a surface of the sheet main body.

8. A method of producing a copper alloy for electric and electronic device, the method comprising:

subjecting a raw material to at least one plastic-working and at least one heat treatment for recrystallization and precipitation to obtain a recrystallized sheet having a recrystallized structure and a predetermined sheet thickness; and
subjecting the recrystallized sheet to a finish plastic-working at a working rate of 1% to 70% to obtain a copper alloy, wherein
the raw material is an alloy comprising:

more than 2.0 mass% to 36.5 mass% of Zn;
0.1 mass% to 0.9 mass% of Sn;
0.05 mass% to less than 1.0 mass% ofNi;
0.5 mass ppm to less than 10 mass ppm of Fe;
0.001 mass% to less than 0.10 mass% of Co;
0.001 mass% to 0.10 mass% of P; and

a balance including Cu and unavoidable impurities,
in which a ratio (Fe+Co)/Ni of a total content of Fe and Co to a Ni content satisfies 0.002≤(Fe+Co)/Ni<1.5 by atomic ratio,
a ratio (Ni+Fe+Co)/P of a total content (Ni+Fe+Co) of Ni, Fe, and Co to a P content satisfies 3<(Ni+Fe+Co)/P<15 by atomic ratio, and
a ratio Sn/(Ni+Fe+Co) of a Sn content to the total content (Ni+Fe+Co) of Ni, Fe, and Co satisfies 0.3<Sn/(Ni+Fe+Co)<5 by atomic ratio,
in the copper alloy, a fraction of measurement points having a CI value of 0.1 or less is 70% or less, when, for the $\alpha$ phase, a measurement using an EBSD method is performed at measurement intervals of 0.1 $\mu$m steps in a measurement area of 1000 $\mu m^2$ or more and an analysis is made using data analysis software OIM, and

the copper alloy includes precipitates containing P and at least one element selected from the group consisting of Fe, Ni, and Co.

9. The method of producing copper alloy for electric and electronic device according to claim 8, further comprising:

low-temperature annealing in which the recrystallized sheet after the final plastic-working is heated at 50°C to 800°C for 0.1 seconds to 24 hours.

10. A conductive component for an electric and electronic device comprising:

the copper alloy for an electric and electronic device according to any one of claims 1 to 3.

11. A terminal comprising:

the copper alloy for an electric and electronic device according to any one of claims 1 to 3.

12. A conductive component for an electric and electronic device comprising:

the copper alloy sheet for an electric and electronic device according to claim 6.

13. A terminal comprising:

the copper alloy sheet for an electric and electronic device according to claim 6.

14. A conductive component for an electric and electronic device comprising:

the copper alloy sheet for an electric and electronic device according to claim 7.

15. A terminal comprising:

the copper alloy sheet for an electric and electronic device according to Claim 7.

FIG. 1

FIG. 2

FIG. 3

## INTERNATIONAL SEARCH REPORT

| | International application No. |
|---|---|
| | PCT/JP2013/068834 |

### A. CLASSIFICATION OF SUBJECT MATTER
*C22C9/04*(2006.01)i, *C22F1/08*(2006.01)i, *C25D7/00*(2006.01)i, *H01B1/02*
(2006.01)i, *H01B5/02*(2006.01)i, *H01B13/00*(2006.01)i, *C22F1/00*(2006.01)n

According to International Patent Classification (IPC) or to both national classification and IPC

### B. FIELDS SEARCHED

Minimum documentation searched (classification system followed by classification symbols)
C22C1/00-49/14, C22F1/00-3/02, C25D7/00, H01B1/02, H01B5/02, H01B13/00

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2007-84920 A (Nippon Mining & Metals Co., Ltd.), 05 April 2007 (05.04.2007), (Family: none) | 1-15 |
| A | WO 2010/134210 A1 (Dowa Metaltech Co., Ltd.), 25 November 2010 (25.11.2010), & JP 2010-270355 A & US 2012/0049130 A1 & KR 10-2012-0011309 A | 1-15 |
| A | JP 2011-184775 A (Kobe Steel, Ltd.), 22 September 2011 (22.09.2011), & DE 102011013399 A1 & CN 102191402 A & KR 10-2011-0102242 A | 1-15 |

| ☒ Further documents are listed in the continuation of Box C. | ☐ See patent family annex. |
|---|---|

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 20 August, 2013 (20.08.13) | 03 September, 2013 (03.09.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2013/068834

C (Continuation).   DOCUMENTS CONSIDERED TO BE RELEVANT

| Category* | Citation of document, with indication, where appropriate, of the relevant passages | Relevant to claim No. |
|---|---|---|
| A | WO 2012/026610 A1 (The Furukawa Electric Co., Ltd.), 01 March 2012 (01.03.2012), & JP 2012-177199 A         & JP 2012-180593 A & JP 5158915 B          & EP 2610358 A & CN 103069025 A        & TW 201211282 A | 1-15 |

Form PCT/ISA/210 (continuation of second sheet) (July 2009)

**EP 2 944 703 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2013002112 A
- JP H533087 B
- JP 2006283060 A
- JP 3953357 B
- JP 3717321 B